(19) Europäisches Patentamt
European Patent Office
Office européen des brevets

(11) **EP 3 267 499 B1**

(12) **EUROPEAN PATENT SPECIFICATION**

(45) Date of publication and mention of the grant of the patent:
**04.09.2019 Bulletin 2019/36**

(51) Int Cl.:
***C08K 3/20*** *(2006.01)*      ***H01L 33/56*** *(2010.01)*
*H01L 33/50* *(2010.01)*      *H01L 33/58* *(2010.01)*

(21) Application number: **15884490.2**

(22) Date of filing: **06.03.2015**

(86) International application number:
**PCT/JP2015/056643**

(87) International publication number:
**WO 2016/142992 (15.09.2016 Gazette 2016/37)**

(54) **COMPOSITION FOR FORMING LIGHT SCATTERING COMPOSITE BODY, LIGHT SCATTERING COMPOSITE BODY AND METHOD FOR PRODUCING THE SAME**

ZUSAMMENSETZUNG ZUR FORMUNG EINES LICHTSTREUUNGSVERBUNDKÖRPERS, LICHTSTREUUNGSVERBUNDKÖRPER UND VERFAHREN ZUR HERSTELLUNG DAVON

COMPOSITION POUR FORMATION D'UN CORPS COMPOSITE DE DIFFUSION DE LUMIÈRE, CORPS COMPOSITE DE DIFFUSION DE LUMIÈRE ET SON PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**10.01.2018 Bulletin 2018/02**

(73) Proprietor: **Sumitomo Osaka Cement Co., Ltd. Tokyo 102-8465 (JP)**

(72) Inventors:
• **OTSUKA, Takeshi**
**Tokyo 102-8465 (JP)**

• **HARADA, Kenji**
**Tokyo 102-8465 (JP)**

(74) Representative: **Becker Kurig Straus Patentanwälte Bavariastrasse 7 80336 München (DE)**

(56) References cited:
**WO-A1-2007/049573      WO-A1-2013/172476**
**JP-A- 2005 252 222      JP-A- 2008 120 848**
**JP-A- 2014 179 565      US-A1- 2015 021 643**

## Description

Technical Field

The present invention relates to a composition for forming a light scattering composite, a light scattering composite, and a method for producing the same.

Background Art

In a white optical semiconductor light emitting device in which a blue optical semiconductor light emitting element and a phosphor are combined with each other, white light (pseudo-white) is obtained by combining blue light emitted from the blue optical semiconductor light emitting element and light whose wavelength is converted by the phosphor. As this type of the white optical semiconductor light emitting device, there are a type in which a blue optical semiconductor light emitting element and a yellow phosphor are combined with each other, and a type in which a blue optical semiconductor light emitting element, a green phosphor, and a red phosphor are combined with each other. However, since the light source (color of light emitted of the optical semiconductor light emitting element) is blue light, it becomes white light including many blue components. In particular, the white optical semiconductor light emitting device in which a blue optical semiconductor light emitting element and a yellow phosphor are combined with each other includes significantly many blue components.

Since the white optical semiconductor light emitting device in which a blue optical semiconductor light emitting element and a phosphor are combined with each other significantly includes the blue components, retinal diseases of the eye due to blue light, physiological damage to the skin, physiological influences on the level of awakening, an autonomic nervous function, body clock, melatonin secretion, and the like are pointed out. In addition, there is recently a growth in the market for optical semiconductor light emitting devices in illumination uses, a development of optical semiconductor light emitting devices with higher luminance is in progress, and thus, human bodies are increasingly exposed to blue light.

Here, in order to suppress the irradiation of blue light from a white optical semiconductor light emitting device and enhance a white light luminance, it is carried out to disperse light scattering particles in the white optical semiconductor light emitting device (see, for example, Patent Literature Nos. 1 and 2) .

Above all, Patent Literature No. 1 aims to facilitate solving the problems in color unevenness and light extraction efficiency by providing a light scattering layer having particles with an average particle diameter D satisfying 20 nm < D $\leq 0.4 \times \lambda/\pi$ (in which $\lambda$ is the light emitting wavelength of the blue optical semiconductor light emitting element) dispersed therein on the side of light emitting side of a phosphor layer. Further, Patent Literature No. 2 aims to enhance a luminance by incorporating particles having an average primary particle diameter of 3 nm or more and 20 nm or less as the light scattering particles in or above a phosphor-containing light conversion layer to provide a light scattering layer, and thus to reduce blue light components.

Patent Literature No. 3 discloses surface modified metal oxide particles having a particle diameter between 3 and 10 nm for the use in a composition for sealing an optical semiconductor device.

Literature List

Patent Literature

[Patent Literature No. 1] Japanese Laid-open Patent Publication No. 2011-129661
[Patent Literature No. 2] Japanese Laid-open Patent Publication No. 2014-4514C
[Patent Literature No. 3] United States Patent Application US 2015/0021643 A1

Summary of Invention

Technical Problem

However, as the scattering particles described in Patent Literature Nos. 1 and 2, ordinary oxide particles are used, and further, in a view that light scattering is usually presumed to be caused by Rayleigh scattering, a light scattering ability is proportional to a content of light scattering particles. As a result, in order to further suppress blue light irradiation and enhance a white light luminance, it has been necessary to increase a content of the light scattering particles in a light scattering layer.

In addition, in particular, in Patent Literature No. 1, in a case where the particle diameters of individual light scattering particles are increased in order to enhance the light scattering ability in the light scattering particles, settling of the light scattering particles occurs in an uncured resin which serves as a raw material for forming a light scattering layer, and therefore, there has been a problem that a uniform scattering layer is not obtained.

The present invention has an object to provide a composition for forming a light scattering composite, capable of providing a white optical semiconductor light emitting device which has excellent light transmitting properties and scattering properties even if a content of light scattering particles is reduced, and as a result, further suppresses blue light irradiation and enhances a white light luminance, while enhancing color rendering properties; a light scattering composite; and a method for producing the same.

Solution to Problem

The present inventors have conducted extensive studies in order to solve the above problems, and as a result, they have found that by controlling the surface modification state and an average dispersed particle diameter of the surface-modified inorganic oxide particles while reducing a content of surface-modified inorganic oxide particles constituting light scattering particles in a composition for forming a light scattering composite up to a certain value, light scattering properties can be enhanced while a reduction in the light transmitting properties of a light scattering composite formed by curing the composition for forming a light scattering composite can be suppressed. Thus, the present inventors have reached the present invention. That is, the present invention as follows.

[1] A composition for forming a light scattering composite, including surface-modified inorganic oxide particles surface-modified by a surface modification material having one or more functional groups selected from an alkenyl group, an H-Si group, and an alkoxy group, and an uncured matrix resin composition, in which an average dispersed particle diameter of the surface-modified inorganic oxide particles is 3 nm or more and 150 nm or less, and a content of the surface-modified inorganic oxide particles is 0.01% by mass or more and 15% by mass or less in a total solid content.

[2] The composition for forming a light scattering composite as described in [1], in which a transmittance Ta at a wavelength of 550 nm measured with an integrating sphere with respect to the composition before curing and a transmittance Tb at a wavelength of 550 nm measured with an integrating sphere with respect to a cured product after curing meet a relationship of Expression (1).

$$Tb/Ta \leq 0.90 \cdots \text{Expression (1)}.$$

[3] The composition for forming a light scattering composite as described in [1] or [2], further including phosphor particles.

[4] A light scattering composite formed by curing the composition for forming a light scattering composite as described in any one of [1] to [3], in which at least some of the surface-modified inorganic oxide particles form associated particles, and an average particle diameter of all particles formed by the surface-modified inorganic oxide particles is 10 nm or more and 1,000 nm or less.

[5] The light scattering composite as described in [4], in which all particles formed by the surface-modified inorganic oxide particles are uniformly dispersed in the light scattering composite.

[6] A method for producing a light scattering composite, including a step of curing a composition for forming a light scattering composite, including surface-modified inorganic oxide particles surface-modified by a surface modification material having one or more functional groups selected from an alkenyl group, an H-Si group, and an alkoxy group, and an uncured matrix resin composition, in which an average dispersed particle diameter of the surface-modified inorganic oxide particles is 3 nm or more and 150 nm or less, and a content of the surface-modified inorganic oxide particles is 0.01% by mass or more and 15% by mass or less, in which during curing, at least some of dispersed particles in the composition for forming a light scattering composite are associated to form associated particles in a matrix resin.

[7] The method for producing a light scattering composite as described in [6], in which curing is carried out so that an average particle diameter of all particles formed by the surface-modified inorganic oxide particles in the light scattering composite is larger than the average dispersed particle diameter in the composition for forming a light scattering composite, and is 10 nm or more and 1,000 nm or less.

Advantageous Effects of Invention

According to the present invention, it is possible to provide a composition for forming a light scattering composite, having excellent light transmitting properties and scattering properties, a light scattering composite, and a method for producing the same.

Brief Description of Drawings

FIG. 1 is a schematic cross-sectional view illustrating an example of an optical semiconductor light emitting device, prepared using a light scattering composition of the present invention.
FIG. 2 is a schematic cross-sectional view illustrating another example of an optical semiconductor light emitting device prepared using a light scattering composition of the present invention.
FIG. 3 is a schematic cross-sectional view illustrating still another example of an optical semiconductor light emitting device prepared using a light scattering composition of the present invention.
FIG. 4 is a schematic cross-sectional view illustrating even still another example of an optical semiconductor light emitting device prepared using a light scattering composition of the present invention.

Description of Embodiments

[Composition for Forming Light Scattering Composite]

The composition for forming a light scattering composite of the present invention includes surface-modified inorganic oxide particles surface-modified by a surface modification material having one or more functional groups selected from an alkenyl group, an H-Si group, and an alkoxy group, and an uncured matrix resin composition, in which an average dispersed particle diameter of the surface-modified inorganic oxide particles is 3 nm or more and 150 nm or less, and a content of the surface-modified inorganic oxide particles is 0.01% by mass or more and 15% by mass or less in a total solid content.

Within a range not interfering with the effect of the present invention, the composition for forming a light scattering composite of the present invention may further include a solvent, a surfactant, a dispersant, a stabilizer, an antioxidant, or the like. Incidentally, the composition may also include particles including an organic resin, in addition to the inorganic oxide particles.

Furthermore, among these, the solvent is a volatile component (non-solid content), and further, the amount of a surfactant, a dispersant, a stabilizer, an antioxidant, and particles including an organic resin is very small, as compared to that of the matrix resin composition. Accordingly, even if a content of the surface-modified inorganic oxide particles is close to the content rate with respect to a total amount of the inorganic oxide particles and the matrix resin composition in the composition for forming a light scattering composite, there is no substantial difference, which is thus not problematic.

[Surface-Modified Inorganic Oxide Particles]

The surface-modified inorganic oxide particles in the present invention are surface-modified inorganic oxide particles surface-modified by a surface modification material having one or more functional groups selected from an alkenyl group, an H-Si group, and an alkoxy group. The surface-modified inorganic oxide particles may further be surface-treated with components other than the surface modification material, such as a surfactant and an organic acid, but preferably include surface-modified inorganic oxide particles surface-modified by the surface modification material.

As the inorganic oxide particles, particles including materials having no light absorption in a wavelength region in which the light scattering composite of the present invention is used are preferably selected and used. Examples of the materials having no light absorption in near-infrared to visible light regions include metal oxides such as $ZrO_2$, $TiO_2$, ZnO, $Al_2O_3$, $SiO_2$, and $CeO_2$, and a light scattering composite including these particles as the light scattering particles can be suitably used in a white optical semiconductor light emitting device (white light emitting diode).

On the other hand, it is also possible to provide wavelength characteristics for the light scattering composite by forming inorganic oxide particles using a material having absorption at a specific wavelength. Further, it is also possible to regulate light scattering properties, light transmitting properties, or the like by selecting a refractive index of the inorganic oxide particles.

The average primary particle diameter of the inorganic oxide particles is preferably 3 nm or more and 50 nm or less. Further, the average primary particle diameter is preferably 4 nm or more and 40 nm or less, and more preferably 5 nm or more and 20 nm or less. With an average primary particle diameter of less than 3 nm, since the scattering effect is small, the sufficient scattering characteristics cannot be expressed in a light scattering composite including the light scattering particles, and therefore, there is a concern that an effect of providing a light scattering composite may not be obtained. On the other hand, if the average primary particle diameter is more than 50 nm, from the viewpoint that scattering becomes excessively significant, particularly in a case where associated particles which will be described later are formed, and thus, multiple scattering easily occurs within the light scattering composite, light incident on the light scattering composite is confined in the light scattering composite, and accordingly, there is a concern that an effect of providing a light scattering composite may not be obtained.

Furthermore, in order to set the average primary particle diameter of the inorganic oxide particles to 3 nm or more and 50 nm or less, it is preferable that 98% or more of the inorganic oxide particles are in a particle diameter range of 1 nm or more and 100 nm or less.

Moreover, the average primary particle diameter of the inorganic oxide particles is determined by, for example, selecting arbitrary 50 or more particles from an image obtained by electron microscopic observation, and the particle diameters thereof are determined and averaged. On the other hand, if the primary particle diameter of the inorganic oxide particles is in a nanometer size, the average primary particle diameter of the inorganic oxide particles may be a Scherrer diameter obtained by X-ray diffraction. This is caused by a fact that if the primary particle diameter is in a nanometer size, there is a less possibility that one particle is formed of a plurality of crystallites, and thus, the average primary particle diameter and the Scherrer diameter are substantially the same as each other.

Next, the surface-modified inorganic oxide particles in the composition for forming a light scattering composite may be dispersed in the state of primary particles alone, in the state of secondary particles in which a plurality of primary particles are agglomerated, or in the state of primary particles and secondary particles are mixed. Hereinafter, the surface-modified inorganic oxide particles which are dispersed in such a state is sometimes referred to as "dispersed particles".

It is necessary for an average particle diameter of these dispersed particles, that is, an average dispersed particle diameter to be 3 nm or more and 150 nm or less. Further, the average dispersed particle diameter is preferably 3 nm or more and 120 nm or less, and more preferably 5 nm or more and 100 nm or less. As described above, since the lower limit value of the average primary particle diameter of the inorganic oxide particles is 3 nm, there is no case where the average dispersed particle diameter is less than 3 nm. On the other hand, if the average dispersed particle diameter is more than 150 nm, the surface-modified inorganic oxide particles easily settle in the composition for forming a light scattering composite, and therefore, there is a concern that various particles formed from the surface-modified inorganic oxide particles may not exist homogeneously (may be not dispersed uniformly) in a light scattering composite obtained by curing the composition for forming a light scattering composite, or the particle diameters of associated particles formed from the inorganic oxide particles are more than 1,200 nm. Further, by setting the average dispersed particle diameter to 150 nm or less, the light scattering in the particles can be suppressed, and accordingly, the transparency in the composition for forming a light scattering composite can be maintained.

Thus, it is intended that the transparency in the composition for forming a light scattering composite is maintained while the light scattering characteristics in a cured product (that is, a light scattering composite) formed by curing the composition for forming a light scattering composite, as described later, are enhanced by formation of associated particles, and the like. That is, in the present invention, a transmittance Ta at a wavelength of 550 nm measured with an integrating sphere with respect to the composition for forming a light scattering composite and a transmittance Tb at a wavelength of 550 nm measured with an integrating sphere with respect to a cured product formed by curing the composition for forming a light scattering composite preferably have a relationship of Expression (1).

$$Tb/Ta \leq 0.90 \cdots \text{Expression (1).}$$

Moreover, in order to set an average dispersed particle diameter of the inorganic oxide particles to 3 nm or more and 150 nm or less, it is preferable that 98% or more of the inorganic oxide particles is within a particle diameter range of 1 nm or more and 200 nm or less.

Incidentally, the average dispersed particle diameter of the inorganic oxide particles can also be determined by, for example, determining a particle size distribution by a dynamic light scattering method, using a composition for forming a light scattering composite, including the particles, and calculating the arithmetic average of the values thereof.

As described later, the light scattering composite of the present invention can be suitably used in a white optical semiconductor light emitting device which emits blue or near-ultraviolet rays with an optical semiconductor light emitting device, in particular, an optical semiconductor light emitting element, and performs wavelength conversion of some of blue or near-ultraviolet to yellow by a phosphor.

The light scattering composite in this case emits light in an optical semiconductor light emitting element, and is required to have two actions of an action of returning blue or near-ultraviolet-luminous light components that have not been wavelength-converted in a phosphor layer and have directly passed through the phosphor layer to the phosphor layer, and an action of extracting the converted light components of yellow light or the like, which have been wavelength-converted in the phosphor layer, outside as they are while not dispersing the converted light components, if possible.

Also in this case, the average primary particle diameter of the inorganic oxide particles is preferably 3 nm or more and 50 nm or less. That is, in a case where the average primary particle diameter of the surface-modified inorganic oxide particles is less than 3 nm, the scattering characteristics with respect to the blue or near-ultraviolet-luminous light components are insufficient, and therefore, the blue or near-ultraviolet ray color of light emitted components is emitted outside as it is (while not being scattered) . As a result, since the amount of light incident on the phosphor is decreased, and thus, the amount of the light components which have been wavelength-converted by the phosphor is also not increased, enhancement in the luminance of the white optical semiconductor light emitting device cannot be facilitated. Moreover, the physiological effects by the blue light tend to be generated. On the other hand, if the average primary particle diameter is more than 50 nm, in particular, in a case where associated particles which will be described later are formed, the blue or near-ultraviolet-luminous light components are not only sufficiently scattered, but also the converted light components which are wavelength-converted in the phosphor layer are also scattered, and thus, are less likely to be emitted from the white optical semiconductor light emitting device, whereby the luminance is also reduced.

That is, even in a case where the light scattering composite of the present invention is applied to the white optical semiconductor light emitting device, if the average primary particle diameter of the surface-modified inorganic oxide particles is 3 nm or more and 50 nm or less, enhancement in the luminance of the white optical semiconductor light emitting device and reduction in the color of the blue or near-ultraviolet ray-emitting component can also be facilitated. Therefore, such the average primary particle diameter of the surface-modified inorganic oxide particles can be suitably used. Similarly, if the average dispersed particle diameter of the surface-modified inorganic oxide particles in the composition for forming a light scattering composite is also 3 nm or more and 150 nm or less, it can be suitably used in the white optical semiconductor light emitting device.

A content of the surface-modified inorganic oxide particles in the composition for forming a light scattering composite is 0.01% by mass or more and 15% by mass or less, with respect to a total amount of the composition for forming a light scattering composite. The content of the surface-modified inorganic oxide particles is preferably 0.01% by mass or more and 10% by mass or less, and more preferably 0.1% by mass or more and 5% by mass or less, with respect to a total amount of the composition for forming a light scattering composite.

If the content of the surface-modified inorganic oxide particles in the composition for forming a light scattering composite is less than 0.01% by mass, the amount of surface-modified inorganic oxide particles, that is, light scattering particles in a light scattering composite obtained by curing the composition for forming a light scattering composite is too small, and thus, a light scattering effect is not obtained. On the other hand, if the content of the surface-modified inorganic oxide particles in the composition for forming a light scattering composite is more than 15% by mass, in particular, in a case where associated particles which will be described later are formed, the amount of surface-modified inorganic oxide particles (light scattering particles) is too large, and therefore, extreme scattering is caused, light incident on the light scattering composite is confined in the light scattering composite, and thus, an effect of providing a light scattering composite is not obtained. That is, by setting the content of the surface-modified inorganic oxide particles in the composition for forming a light scattering composite to 0.01% by mass or more and 15% by mass or less, a light scattering composite having a good balance between scattering properties and light transmitting properties can be obtained.

In addition, if a light scattering composite obtained from such a composition for forming a light scattering composite is applied to a white optical semiconductor light emitting device, the light extraction efficiency from the white optical semiconductor light emitting element can be further enhanced, and thus an optical semiconductor light emitting device with a higher luminance can be provided.

(Surface Modification of Inorganic Oxide Particles)

The surface-modified inorganic oxide particles in the present invention are present as dispersed particles in the state where an average dispersed particle diameter thereof is 3 nm or more and 150 nm or less in the uncured composition for forming a light scattering composite. The reason therefor is that a light scattering composite obtained by curing the composition for forming a light scattering composite as described above, the uniformity of various particles formed by surface-modified inorganic oxide particles is secured, or the particle diameter of the associated particles is prevented from being more than 1,200 nm.

On the other hand, in the light scattering composite, it is preferable that a plurality of particles in at least some of the surface-modified inorganic oxide particles are associated to form associated particles, as described later. These associated particles may be formed by association of a plurality of primary particles in the composition for forming a light scattering composite, may be formed by association of a plurality of secondary particles in the composition for forming a light scattering composite, or may be formed by association of a plurality of primary particles and secondary particles in the composition for forming a light scattering composite. Accordingly, the surface-modified inorganic oxide particles in the light scattering composite may include primary particles in which the primary particles in the composition for forming a light scattering composite are maintained as they are, secondary particles in which the secondary particles in the composition for forming a light scattering composite are maintained as they are, or associated particles formed by primary particles and secondary particles in the composition for forming a light scattering composite. Hereinafter, in the light scattering composite, all of the particles formed by these surface-modified inorganic oxide particles may be collectively referred to as "light scattering particles".

Moreover, all particles (light scattering particles) formed by these surface-modified inorganic oxide particles preferably have an average particle diameter of 10 nm or more and 1,000 nm or less. The average particle diameter is more preferably 50 nm or more and 1,000 nm or less, and still more preferably 80 nm or more and 1,000 nm or less.

Furthermore, it is necessary for an average particle diameter of the light scattering particles to be larger than an average dispersed particle diameter of the dispersed particles in the composition for forming a light scattering composite.

In addition, it is preferable that these light scattering particles are uniformly dispersed in a matrix resin, and it is particularly preferable that the associated particles are uniformly dispersed in a matrix resin. Here, "being uniformly dispersed" indicates that when an arbitrary portion of the formed light scattering composite is observed, the number and the average particle diameter of the light scattering particles in this portion represent substantially uniform values. In the present specification, the same shall apply hereinafter.

The "being uniformly dispersed" can be evaluated in the following manner.

That is, the number and the average particle diameter of the light scattering particles, which are subjects to be evaluated, are factors that give an effect on the scattering state of light in combination, and therefore, as these values are changed, the light scattering characteristics are also changed. Accordingly, an integrated transmittance which is a method for evaluating light scattering characteristics is measured at a plurality of parts of the light scattering composite, and if the values are within a certain range, the light scattering particles in the light scattering composite can be determined "being uniformly dispersed".

Here, as a measurement sample, a light scattering composite which has been flaked is preferably used. For example, if the light scattering composite is in a sheet shape, a sample which has been flaked in the direction of a plane thereof can be used. More simply, the light scattering composite in the sheet shape is bisected on the surface side and the back surface side, and each of them may be used as the measurement sample.

Incidentally, the measurement wavelength is not particularly limited, but a wavelength at which light scattering characteristics are more reflected is preferable. For example, in the light scattering composite used in a white optical semiconductor light emitting device, blue light in the vicinity of a wavelength of 460 nm which is the light emitting wavelength of an optical semiconductor light emitting element or yellow light in the vicinity of a wavelength of 550 nm, which is the emitted light of a phosphor can be taken for a measurement wavelength, and in particular, blue light is preferably used.

In addition, if the variation width of the integrated transmittance in the arbitrary portion, thus measured, is within 10%, the light scattering particles in the light scattering composite can be determined to be "being uniformly dispersed". The variation width is more preferably within 5%.

In order to make the surface-modified inorganic oxide particles show such a behavior, it is necessary to control the dispersed state in the matrix resin composition or the interfacial affinity with the matrix resin composition, as well as to control the dispersion state in the matrix resin and the interfacial affinity in the matrix resin.

Specifically, first, with regard to the matrix resin composition, it becomes important to increase the compatibility by surface-treating the inorganic oxide particles with a surface modification material having a skeleton and a functional group similar to those of the matrix resin composition. By using the surface-modified inorganic oxide particles having an increased compatibility, it is possible to disperse the inorganic oxide particles in the matrix resin composition such that an average dispersed particle diameter thereof becomes 150 nm or less.

Next, when the composition for forming a light scattering composite is cured to form a light scattering composite, the matrix resin composition which is in the state of a low molecular product or an oligomer when uncured undergoes an increase in the molecular weight and a crosslinking during a curing reaction. If the surface modification is inappropriate, inorganic oxide particles are excluded as a foreign material from the resin components during curing reaction, thereby causing phase separation. As a result, the inorganic oxide particles are associated and aggregated to form coarse particles, and white turbidity occurs. The phase separation and the formation of coarse particles are noticeably observed, in particular, by a reduction in the system viscosity during the heating and curing of the matrix resin, and although it depends on the crosslinking density of the resin, the association and aggregation rate of the inorganic oxide particles becomes faster, and as a result, they are excluded from the cured product of the matrix resin, and white turbidity occurs.

In order to prevent the phase separation and the formation of coarse particles (white turbidity) and disperse all of the particles formed from the surface-modified inorganic oxide particles in the light scattering composite in the matrix resin, it is necessary to secure the interfacial affinity between the surface of the surface-modified inorganic oxide particles and the matrix resin. As a result, the surface of the inorganic oxide particles (non-modified particles) is preferably covered with a surface modification material having a structure with good compatibility with the structure of the matrix resin.

Specifically, when the matrix resin composition which is a resin monomer or oligomer for forming the matrix resin, and is an uncured body of a liquid forms a matrix resin composition, it is sufficient as long as a reactive group used in the polymerization among the resin monomers or oligomers is contained in the surface modification material. Here, a silicone-based sealing material which is a matrix resin composition preferably has at least one of an H-Si group, an alkenyl group, and an alkoxy group as a reactive group. Accordingly, a surface modification material having at least one functional group selected from an alkenyl group, an H-Si group, and an alkoxy group is used, and the surface of the light scattering particles is modified by the surface modification material.

That is, at least some of the surfaces of the inorganic oxide particles are surface-modified by a surface modification material having one or more functional groups selected from an alkenyl group, an H-Si group, and an alkoxy group, whereby surface-modified inorganic oxide particles are constituted. That is, at least some of the surfaces of the inorganic oxide particles are covered with a surface modification material having such a functional group.

Examples of the surface modification material having one or more functional groups selected from an alkenyl group, an H-Si group, and an alkoxy group include vinyl trimethoxysilane, dimethyl silicone having an alkoxy end and a vinyl end, methylphenyl silicone having an alkoxy end and a vinyl end, phenyl silicone having an alkoxy end and a vinyl end, methacryloxypropyl trimethoxysilane, acryloxypropyl trimethoxysilane, a carbon-carbon unsaturated bond-containing fatty acid such as methacrylic acid, dimethyl hydrogen silicone, methylphenyl hydrogen silicone, phenyl hydrogen silicone, dimethylchlorosilane, methyldichlorosilane, diethyl, chlorosilaneethyldichlorosilane, methylphenylchlorosilane, diphenylchlorosilane, phenyldichlorosilane, trimethoxysilane, dimethoxysilane, monomethoxysilane, triethoxysilane, diethoxymonomethylsilane, monoethoxydimethylsilane, methylphenyl dimethoxysilane, diphenyl monomethoxysilane, methylphenyl diethoxysilane, and diphenyl monoethoxysilane.

The surface modification amount for the surfaces of the inorganic oxide particles with the surface modification material having one or more functional groups selected from an alkenyl group, an H-Si group, and an alkoxy group is preferably, in a case of using metal oxide particles as the inorganic oxide particles, 1% by mass or more and 50% by mass or less, in terms of the mass. By setting the surface modification amount to a range of 1% by mass or more and 50% by mass or less, it is possible that the surface-modified inorganic oxide particles exist as dispersed particles, which are uniformly dispersed in the state where an average dispersed particle diameter thereof is 150 nm or less, in the matrix resin composition, whereas for the cured light scattering composite, it is possible that all of the particles, in particular, associated particles, formed from the surface-modified inorganic oxide particles, can be uniformly dispersed in the matrix resin, in the state where at least some of the surface-modified inorganic oxide particles form associated particles. Accordingly, by using surface-modified inorganic oxide particles having a surface modification amount in the above range, a light scattering composite having high scattering characteristics can be obtained.

On the other hand, if the surface modification amount is less than 1% by mass, the number of bonding points of the functional group between the surface modification material and the matrix resin composition is insufficient, and therefore, the light scattering particles are less likely to be well dispersed in the matrix resin composition, and even when the light scattering particles are dispersed, the light scattering particles are separated from the matrix resin phase in the process of curing the light scattering composite, and aggregated. As a result, there is a concern that a reduction in the light transmitting properties or a reduction in the hardness of the light scattering composite may occur.

Moreover, in a case where the surface modification amount is more than 50% by mass, the number of bonding points of the functional group between the surface modification material and the matrix resin composition is increased, and thus, there are cases where the light scattering particles cannot be only uniformly dispersed in the monodispersion state in which the state of the primary particles is maintained in the matrix resin composition, but also the monodispersion of the light scattering particles is maintained even in the process of curing the light scattering composite, and thus, there are cases where partial association does not occur. As a result, it cannot be expected that a light scattering ability is enhanced due to the formation of associated particles in the light scattering conversion layer or the light scattering layer (an effect of providing a sufficient scattering ability with a smaller amount of light scattering particles). Further, with a surface modification amount in the range of more than 50% by mass and 80% by mass or less, it is difficult to expect an effect from formation of associated particles, but a good bonding state between the light scattering particles and the matrix resin is maintained, and thus, the characteristics as the light scattering composite are maintained. On the other hand, if the surface modification amount is more than 80% by mass, the number of bonding points of the functional group between the surface modification material and the matrix resin composition is excessively increased, and thus, there is a concern that the cured body may be easily embrittled and cracked.

The surface modification amount is more preferably 3% by mass or more and 50% by mass or less, and more preferably 5% by mass or more and 40% by mass or less.

Moreover, in order to control and adjust the phase separation during curing of the resin, that is, the association and aggregation state of the surface-modified inorganic oxide particles, a polymer-type surface modification material and an oligomer-type surface modification material can be used, together with a surface modification material having one or more functional groups selected from an alkenyl group, an H-Si group, and an alkoxy group.

Examples of the polymer-type surface modification material and the oligomer-type surface modification material include polymer-type surface modification materials and oligomer-type surface modification materials, each having a similar skeleton to that of the matrix resin. For example, if the matrix resin is a silicone resin, a silicone polymer having a methyl group and a phenyl group can be suitably used as the polymer-type surface modification material; and a phenyl silicone having two alkoxy ends, a methylphenyl silicone having two alkoxy ends, an alkoxy group-containing dimethyl silicone resin, an alkoxy group-containing phenyl silicone resin , and an alkoxy group-containing methylphenyl silicone resin can be suitably used as the oligomer-type surface modification material.

The molecular weights of the polymer-type surface modification material and the oligomer-type surface modification material are preferably 0.1 to 50 times the molecular weight of the matrix resin. Further, the treatment amounts of the polymer-type surface modification material and the oligomer-type surface modification material are preferably 0.1% by mass or more and 10% by mass or less with respect to the mass of the inorganic oxide particles.

In addition, even in a case where the surface modification material is used together with the polymer-type surface modification material and the oligomer-type surface modification material, a total amount thereof, that is, a total amount of the surface modification material having one or more functional groups selected from an alkenyl group, an H-Si group, and an alkoxy group, the polymer-type surface modification material and the oligomer-type surface modification material is preferably 1% by mass or more and 50% by mass or less, more preferably 3% by mass or more and 50% by mass or less, and still more preferably 5% by mass or more and 40% by mass or less, with respect to the mass of the inorganic oxide particles in a case of using metal oxide particles as the inorganic oxide particles.

Thus, in the present invention, by adjusting the composition (the molecular structure or the components of a reactive group) of the surface modification material, and the surface modification amount with respect to the components and the inorganic oxide particles to control the association state of the inorganic oxide particles during curing reaction, at least some of the surface-modified inorganic oxide particles can be dispersed in the light scattering composite in the state where a plurality of particles are associated to form associated particles. The associated particle diameter of these associated particles is preferably 1,200 nm or less.

Examples of a method of surface modification of the surface modification material on the surfaces of the inorganic oxide particles include a dry method of directly mixing or spraying the surface modification material with or onto inorganic oxide particles and a wet method of pouring unmodified particles into at least one kind of solvent selected from water and an organic solvent in which the surface modification material is dissolved, so as to be surface-modified in the solvent. In the present invention, the wet method is preferably used from the viewpoints of excellent properties of controlling the surface modification amount, high uniformity of surface modification, and the like.

[Matrix Resin Composition]

The matrix resin composition is an uncured body of a liquid matrix resin of a resin monomer or oligomer, constituting a matrix resin including surface-modified inorganic oxide particles when the composition for forming a light scattering composite is cured to form a light scattering composite.

Here, the matrix resin to be applied to the light scattering composite is not particularly limited as long as it is a material having no light absorption in a wavelength region in which the light scattering composite of the present invention is used, but since it is basically an optical material, it preferably has resistance to light (light resistance). Further, as described earlier, the light scattering composite of the present invention can be suitably used in a white optical semiconductor light emitting device, but in this case, it is preferable that the light scattering composite is transparent to a visible region (a near-ultraviolet region to a visible region in a case of using a near-ultraviolet optical semiconductor light emitting element as the optical semiconductor light emitting element), and does not damage the reliability (various required performances, for example, durability) of the optical semiconductor light emitting device. Further, in a case where the applications to the high output of the optical semiconductor light emitting element and to the illumination uses are considered, a resin which has been used as a sealing material for optical semiconductor light emitting element in the related art is preferably used. In particular, from the viewpoint of the durability of the light scattering composite, a silicone-based sealing material is preferably used in the matrix resin, and examples thereof include a dimethyl silicone resin, a methylphenyl silicone resin, a phenyl silicone resin, and an organic modified silicone resin.

Accordingly, the matrix resin composition preferably contains a resin monomer or oligomer of a silicone-based resin, such as a resin monomer or oligomer of a dimethyl silicone resin, a resin monomer or oligomer of a methylphenyl silicone resin, a resin monomer or oligomer of a phenyl silicone resin, and a resin monomer or oligomer of an organic modified silicone resin.

In a case of using a silicone resin as the matrix resin of the light scattering composite which is an uncured body of a liquid, the light scattering composite can be obtained by polymerization-curing each of the silicone resin compositions through, for example, an addition type reaction, a fusion type reaction, a radical polymerization reaction, or the like. In particular, it is preferable to select a silicone resin composition having at least one of an H-Si group, an alkenyl group, and an alkoxy group as a reactive group.

As described above, in the composition for forming a light scattering composite, the surface-modified inorganic oxide particles are preferably present in the state where an average dispersed particle diameter thereof is 150 nm or less. On the other hand, in the light scattering composite obtained by curing the composition for forming a light scattering composite, the surface-modified inorganic oxide particles are preferably uniformly dispersed as a whole in the matrix resin in the state where at least some of the surface-modified inorganic oxide particles form associated particles. In addition, in order to disperse the surface-modified inorganic oxide particles uniformly in the matrix resin, the surface-modified inorganic oxide particles are preferably controlled to secure the interfacial affinity between the light scattering particle surface and the matrix resin.

In the present invention, as described above, the structure of the surface modification material has good compatibility with the structure of the matrix resin. That is, it is preferable to select a silicone-based sealing material having at least one of an H-Si group, an alkenyl group, and an alkoxy group as a reactive group as the matrix resin composition, and thus, a surface modification material having one or more functional groups selected from an alkenyl group, an H-Si group, and an alkoxy group is used in the surface modification material.

Thus, in a case where a silicone-based sealing material having at least one of an H-Si group, an alkenyl group, and an alkoxy group is used as the matrix resin composition, the alkenyl group, the H-Si group, and the alkoxy group contained in the surface modification material are bonded to the matrix resin composition in the following manner.

The alkenyl group of the surface modification material is crosslinked by the reaction with an H-Si group in the matrix resin composition. The H-Si group in the surface modification material is crosslinked by the reaction with the alkenyl group in the matrix resin composition. The alkoxy group of the surface modification material is fused through the hydrolysis of the alkoxy group in the matrix resin composition. In a view that the matrix resin and the surface modification material are integrated by such the bond, the light scattering particles can be immobilized in the matrix resin while they are not completely phase-separated and maintain the dispersion state as a whole, and can enhance the denseness of these layers, in the process where the matrix resin composition is cured to form a matrix resin.

Incidentally, by adjusting the composition (the molecular structure or the components of a reactive group) of the surface modification material and the surface modification amount with respect to the inorganic oxide particles, or furthermore, by using a polymer-type surface modification material or an oligomer-type surface modification material, and adjusting the molecular weight thereof to a range of 0.1 to 50 times the molecular weight of the matrix resin, it is possible to control the compatibility between the surface modification material and the resin, and thus, control and adjust the associated particle diameter during curing of the resin.

Moreover, in order to obtain one or both of an effect of further enhancing the interfacial affinity between the surfaces of the surface-modified inorganic oxide particles and the matrix resin, and an effect of modifying a surface modification material having the functional group more efficiently in the process of surface-modifying the inorganic oxide particles, known surface modification materials other than the surface modification material having the functional group can be used in combination.

The uncured body of the matrix resin contained in the matrix resin composition may be used singly or in combination of two or more kinds thereof.

In addition, a content of the matrix resin composition in the composition for forming a light scattering composite is preferably the residue obtained by excluding a content of the surface-modified inorganic oxide particles in the light scattering composition.

(Production of Composition for Forming Light Scattering Composite)

A composition for forming a light scattering composite is obtained by mixing particles including the surface-modified inorganic oxide particles and the matrix resin composition as described above. In the light scattering composite formed by curing the composition for forming a light scattering composite, it is preferable that the surface-modified inorganic oxide particles in the composition for forming a light scattering composite exist in the state where an average dispersed particle diameter thereof is 150 nm or less, in a view that it is preferable that surface-modified inorganic oxide particles including light scattering bodies are uniformly dispersed in the matrix resin.

As a method of uniformly dispersing the surface-modified inorganic oxide particles in the matrix resin composition, there are a method of mixing and dispersing the surface-modified inorganic oxide particles with the matrix resin composition in a mechanical method using a biaxial kneader or the like and a method of mixing a dispersion liquid obtained by dispersing the surface-modified inorganic oxide particles in an organic solvent with the matrix resin composition, and then drying the organic solvent off.

As described later, the light scattering composite of the present invention can be suitably used in an optical semiconductor light emitting device, in particular, a white optical semiconductor light emitting device which emits blue or near-ultraviolet light with an optical semiconductor light emitting element, and wavelength-converts some of the blue or near-ultraviolet light to yellow by a phosphor.

When taking the applications to the white optical semiconductor light emitting device into consideration, the transmittance of the composition for forming a light scattering composite at a wavelength of 460 nm measured with an integrating sphere is preferably set to 40% or more and 95% or less in a case where the sample thickness is set to 1 mm. By setting the transmittance at a wavelength of 460 nm to 40% or more, a reduction in the transmittance of all types of light can be prevented, and thus, the luminance of the optical semiconductor light emitting device can be enhanced. In addition, if the transmittance is 95% or less, the color of light emitted component of the optical semiconductor light emitting element which has not been wavelength-converted by the phosphor is prevented from being significantly emitted toward the outside air phase, and thus, scatters in a direction different from that of the outside air phase. Therefore, the color rendering properties of the optical semiconductor light emitting device can be enhanced. The transmittance at a wavelength of 460 nm is more preferably 50% or more and 90% or less, and still more preferably 60% or more 85% or less.

In addition, in the following description, "transmittance measured with an integrating sphere" is also referred to as an "integrated transmittance" in some cases. Further, "the transmittance measured with linear light, which is a general transmittance measuring method" is referred to "linear transmittance" in some cases.

Furthermore, the transmittance at a wavelength of 550 nm is preferably 75% or more. By setting the transmittance to 75% or more, a reduction in the transmittance of white light in which the color of light emitted of the optical semiconductor light emitting element is combined with a light from wavelength-conversion of the color of light emitted by the phosphor can be prevented, and thus, the luminance of the optical semiconductor light emitting device can be enhanced. The transmittance at a wavelength of 550 nm is more preferably 80% or more, and still more preferably 90% or more.

In order to obtain such the transmittance, a known amount other than the surface modification material in the surfaces of the surface-modified inorganic oxide particles may be adjusted.

[Light Scattering Composite]

The light scattering composite of the present invention is formed by curing the composition for forming a light scattering composite of the present invention, wherein at least some of the surface-modified inorganic oxide particles form associated particles, and an average particle diameter of all particles formed by the surface-modified inorganic oxide particles, that is, the average particle diameter of the light scattering particles is 10 nm or more and 1,000 nm or less.

Accordingly, the light scattering composite of the present invention includes surface-modified inorganic oxide particles surface-modified by a surface modification material having one or more functional groups selected from an alkenyl group, an H-Si group, and an alkoxy group, and a matrix resin, and a content of the surface-modified inorganic oxide particles is 0.01% by mass or more and 15% by mass or less with respect to a total amount of the light scattering composite.

The contents and preferred aspects of the surface-modified inorganic oxide particles are the same as the contents and preferred aspects of the surface-modified inorganic oxide particles included in the composition for forming a light scattering composite.

The matrix resin is a resin, and preferably a transparent resin, which is obtained by curing the matrix resin composition included in the composition for forming a light scattering composite. The contents and preferred aspects of the matrix resin composition are the same as the contents and preferred aspects of the matrix resin composition included in the composition for forming a light scattering composite.

In the light scattering composite of the present invention, from the viewpoint of the scattering properties, at least some of the surface-modified inorganic oxide particles are dispersed in the matrix resin in the state where they form associated particles. These associated particles are formed by association of a plurality of dispersed particles in the composition for forming a light scattering composite. That is, in the associated particles, three kinds of associated particles formed by association of a plurality of primary particles in the composition for forming a light scattering composite, associated particles formed by association of a plurality of secondary particles in the composition for forming a light scattering composite, and associated particles formed by association of a plurality of primary particles and secondary particles in the composition for forming a light scattering composite may be considered, and at least one of these three kinds may be included.

Here, the particle diameters of the associated particles are preferably 1,200 nm or less. Since in a view that if the particle diameters of the associated particles are more than 1,200 nm, scattering is excessively increased, and thus, multiple scattering in the light scattering composite easily occurs, there is a concern that the light incident on the light scattering composite may be confined in the light scattering composite, and thus, an effect of providing the light scattering composite may not be obtained. Further, the lower limit value of the particle diameters of the associated particles may be more than the primary particle diameter from the definition, and it is preferable to define the lower limit of the average particle diameter of the light scattering particles to the value shown below in view of effectiveness.

Thus, the surface-modified inorganic oxide particles in the light scattering composite may further include primary particles in which the primary particles are maintained as they are in the composition for forming a light scattering composite and secondary particles in which the secondary particles are maintained as they are in the composition for forming a light scattering composite, in addition to the associated particles formed by association of one kind or two or more kinds selected from the primary particles and the secondary particles in the composition for forming a light scattering composite. Further, an average particle diameter of all particles formed from these surface-modified inorganic oxide particles in the light scattering composite, that is, the average particle diameter of the light scattering particles is preferably 10 nm or more and 1, 000 nm or less. The average particle diameter of the light scattering particles is more preferably 20 nm or more and 1, 000 nm or less, and still more preferably 50 nm or more and 800 nm or less.

Here, if the average particle diameter of the light scattering particles is less than 10 nm, the scattering ability of light is low, and therefore, there is a concern that the light scattering properties may be reduced, and an effect of incorporating light scattering particle may not be obtained. On the other hand, if the average particle diameter is more than 1,000 nm, the scattering ability as the particles becomes excessively stronger, and therefore, there is a concern that the light incident on the light scattering composite is confined in the light scattering composite, and thus, an effect of providing the light scattering composite may not be obtained.

Furthermore, even with a method for measuring the average particle diameter of the light scattering particles, it is difficult to carry out the measurement using a dynamic light scattering method since the light scattering composite is a cured product. As a result, the average particle diameter can be obtained by, for example, observing a flaked sample of the light scattering composite with a transmission electron microscope (TEM), selecting 50 or more arbitrary light scattering particles, measuring the particle diameters of the respective light scattering particles on the screen, and then determining an average value thereof. As for the particle diameters of the respective light scattering particles, with regard to the surface-modified inorganic oxide particles which are individually present, the particle diameters thereof are taken as the particle diameters of the light scattering particles, whereas in a case where a plurality of surface-modified inorganic oxide particles are overlapped or continuous, all of the plurality of the particles are defined as secondary particles or associated particles, and the particle diameters of all of the secondary particles or associated particles may be taken as particle diameters of the light scattering particles.

Furthermore, the average particle diameter of the light scattering particles becomes larger than the average dispersed particle diameter of the dispersed particles in the composition for forming a light scattering composite. This is because the associated particles are formed by association of the primary particle or the secondary particles in the composition for forming a light scattering composite. Further, in the composition for forming a light scattering composite of the present invention, the upper limit value of the average dispersed particle diameter is set to 150 nm, and therefore, if the average particle diameter of the light scattering particles in the light scattering composite of the present invention is more than 150 nm, it can be clearly determined that associated particles are formed.

Thus, by forming the associated particles, the average particle diameter of the light scattering particles in the light scattering composite becomes larger than the average dispersed particle diameter of the dispersed particles in the composition for forming a light scattering composite, and therefore, a scattering ability for light is increased, and accordingly, a sufficient scattering ability can be expressed with a smaller amount of light scattering particles, as compared with a case where the associated particles are not formed. That is, even when the ratio of the light scattering particles in the light scattering composite formed by molding the composition for forming a light scattering composite of the present invention is set to 10% by mass or less, sufficient light scattering characteristics can be obtained.

For example, in the light scattering composite of the present invention, in a view that the light scattering characteristics are excellent, integrated transmittance can be higher than the linear transmittance. The wavelength for measuring the transmittance is selected depending on the conditions under which the light scattering composite is used, but in a case where the light scattering composite of the present invention is used in a white optical semiconductor light emitting device as described later, it is preferably set to the light emitting wavelength (460 nm) of the blue optical semiconductor light emitting element in the white optical semiconductor light emitting device. The integrated transmittance is higher than the linear transmittance, and further, the difference therebetween (the integrated transmittance - the linear transmittance) is more preferably 25 points or more, and still more preferably 40 points or more.

Moreover, it is preferable that the light scattering particles are uniformly dispersed in the matrix resin, and it is particularly preferable that the associated particles are uniformly dispersed in the matrix resin. In a case where the light scattering particles are localized in a part of the matrix resin, there is a concern that desired light scattering characteristics may not be obtained. Thus, in order to uniformly disperse the light scattering particles, in particular, the associated particles in the matrix resin, as described later, the associated particles are not formed in the state of the composition for forming a light scattering composite, but are preferably formed in a step of curing the composition for forming a light scattering composite to form a light scattering composite.

[Method for Producing Light Scattering Composite]

A method for producing the light scattering composite of the present invention includes a step of curing a composition for forming a light scattering composite, including surface-modified inorganic oxide particles surface-modified by a surface modification material having one or more functional groups selected from an alkenyl group, an H-Si group, and an alkoxy group, and a matrix resin composition, in which a dispersed particle diameter of the surface-modified inorganic oxide particles are 3 nm or more and 150 nm or less, and a content of the surface-modified inorganic oxide particles is 0.01% by mass or more and 15% by mass or less. Further, during curing of the composition for forming a light scattering composite, at least some of dispersed particles formed by being dispersed in the composition for forming a light scattering composite are associated to form associated particles in a matrix resin.

That is, these associated particles are not formed in the state of the composition for forming a light scattering composite, but are formed in a step of curing the composition for forming a light scattering composite to form a light scattering composite.

In the composition for forming a light scattering composite, the surface-modified inorganic oxide particles are uniformly dispersed in the uncured matrix resin composition in the state where an average dispersed particle diameter thereof is 3 nm or more and 150 nm or less. Further, it is preferable that as the matrix resin is cured, a plurality of dispersed particles are associated by causing local phase separation with the matrix resin (composition) in an ultrafine region to form associated particles. Further, it is preferable that this local phase separation occurs within the entire matrix resin composition (composition for forming a light scattering composite), while the respective associated particles are kept in the local region with no mutual bonding. In order to make the surface-modified inorganic oxide particles show such the behavior, the dispersion state of the surface-modified inorganic oxide particles in the matrix resin composition or the interfacial affinity with the matrix resin composition may be controlled, while the dispersion state in the matrix resin or the interfacial affinity with the matrix resin may also be controlled, as described above.

By forming the associated particles in such a configuration, the light scattering composite of the present invention can take a form in which the light scattering particles, in particular, the associated particles are uniformly dispersed in the matrix resin. Incidentally, even when the amount of the light scattering particles included is as small as 10% by mass or less, preferably 5% by mass or less, and more preferably 1% by mass or less, high light scattering properties can be expressed.

With regard to this, in a case where associated particles are not formed during curing of the composition for forming a light scattering composite, that is, in a case where the dispersed particle diameters of the surface-modified inorganic oxide particles in the composition for forming a light scattering composite are 10 to 1,000 nm which are equal to the light scattering particle diameters, the dispersed particle diameters are excessively high, and therefore, the surface-modified inorganic oxide particles easily settle in the uncured matrix resin. As a result, in the light scattering composite obtained by curing the composition for forming a light scattering composite, the light scattering particles are unevenly distributed in a specific direction, that is, are unevenly distributed in the direction of the bottom surface during curing, and therefore, a form in which the light scattering particles are uniformly dispersed cannot be taken.

Furthermore, by forming the associated particles in such a configuration, the integrated transmittance Td at a wavelength of 550 nm of the light scattering composite and the integrated transmittance Tc at a wavelength of 550 nm of the composition for forming a light scattering composite for forming the light scattering composite can meet the relationship of Expression (2) .

$$\mathrm{Td/Tc} \leq 0.90 \cdots \mathrm{Expression} \ (2)$$

That is, in the composition for forming a light scattering composite, since associated particles formed from the surface-modified inorganic oxide particles are not formed, and further, an average dispersed particle diameter of the dispersed particles is as small as 3 nm or more and 150 nm or less, and the scattering ability is also small, a high light transmittance is exhibited. On the other hand, in the light scattering composite, since associated particles are formed, the average particle diameter of the light scattering particles is 10 nm or more and 1, 000 nm or less, and the average particle diameter of the light scattering particles is larger than the average dispersed particle diameter of the dispersed particles, the scattering ability by the particles is also increased, and the light transmittance is reduced. In addition, if the value of Td/Tc is 0. 90 or less, an effect of forming associated particles (an effect of causing an average particle diameter of the light scattering particles to be more than an average dispersed particle diameter of the dispersed particles) can be sufficiently obtained, and thus, a light scattering composite having high light scattering characteristics can be obtained.

A method for curing the composition for forming a light scattering composite is not particularly limited, and for example, curing may be carried out by applying external energy such as light and heat to the composition for forming a light scattering composite. Further, curing may be carried out by adding a polymerization catalyst.

The light scattering composite of the present invention may be a molded body formed by applying a composition for forming a light scattering composite in the form of a solution onto a substrate or pouring the light scattering composite into a mold, followed by curing and molding, or a molded body obtained by melt-knead a composition for forming a light scattering composite using an extruder or the like, then injecting the product into a mold, followed by cooling. Further, the light scattering composite of the present invention may be a laminate in which plate-like bodies obtained by curing the composition for forming a light scattering composite of the present invention are laminated.

In addition, in the above description, the matrix resin composition is referred to as a "resin monomer or oligomer forming a matrix resin", and formation of the matrix resin is basically carried out by polymerization-curing of the composition, but is not necessarily limited thereto. For example, the matrix resin composition may be formed from a solvent soluble resin and a solvent, and formation of the matrix resin may be carried out by removal (drying) of the solvent. In this case, as the surface modification material for the oxide particles, a material, a part of which exhibits solvent-solubility is preferably selected.

Moreover, in the present invention, in a view that the surface modification or the like of the inorganic oxide particles is controlled such that the associated particles are uniformly formed in the matrix resin, there is no particular limitation in the curing method or the curing conditions. However, by employing a method for uniformly carrying out the curing of the composition for forming a light scattering composite, uniform dispersion of the associated particles can be further facilitated.

Since the composition for forming a light scattering composite and the light scattering composite of the present invention have excellent light scattering properties and transmitting properties, they can be applied to various uses in which it is necessary to scatter light while transmitting the light. In particular, the composition for forming a light scattering composite and the light scattering composite of the present invention are suitable for a device including a light source for emitting rays with strong directivity, for example, an optical semiconductor light emitting device.

[Optical Semiconductor Light Emitting Device]

The optical semiconductor light emitting device is a device including an optical semiconductor light emitting element, phosphor particles, and a light scattering composite containing light scattering particles and a matrix resin, and emitting white light. Further, the light scattering particles are inorganic oxide particles which are surface-modified by a surface modification material having one or more functional groups selected from an alkenyl group, an H-Si group, and an alkoxy group, in which at least some of the surface-modified inorganic oxide particles form associated particles, and the average particle diameter of the light scattering particles is 10 nm or more and 1, 000 nm or less. Further, the inorganic oxide particles are particles including a material having no light absorption in the light emitting wavelength region of the optical semiconductor light emitting element.

Moreover, an optical semiconductor light emitting device having such the configuration, in which the light scattering composite has the phosphor particles incorporated thereinto to form a light scattering conversion layer, and a content of the light scattering particles in the light scattering conversion layer is 15% by mass or less, is hereinafter referred to as an "optical semiconductor light emitting device A". Further, an optical semiconductor light emitting device having such the configuration, in which a light conversion layer is formed from a layer including the phosphor particles, a light scattering layer including the light scattering composite is provided on the light conversion layer, and a content of the light scattering particles in the light scattering layer is 15% by mass or less, is hereinafter referred to as an "optical semiconductor light emitting device B". In addition, in the description shown below, in a case where the "optical semiconductor light emitting device" is simply referred to, it indicates both the "optical semiconductor light emitting device A" and the "optical semiconductor light emitting device B".

Furthermore, the "optical semiconductor light emitting device" may have a structure with a combination of the "optical semiconductor light emitting device A" and the "optical semiconductor light emitting device B". That is, by incorporating the phosphor particles into the light scattering composite, a light scattering conversion layer is formed, and a light scattering layer further including the light scattering composite is provided on the light scattering conversion layer. The device having such a configuration is also referred to the "optical semiconductor light emitting device" in the following description.

As described above, in the white optical semiconductor light emitting device in which a blue optical semiconductor light emitting element and a phosphor are combined with each other, white light (pseudo-white) is obtained by combining blue light emitted from the blue optical semiconductor light emitting element and light whose wavelength is converted by the phosphor. Further, in particular, in a white optical semiconductor light emitting device in which a blue optical semiconductor light emitting element and a yellow phosphor are combined with each other, the emitted light includes many blue components, and thus, physiological effects have been pointed out. Further, the market in illumination uses of the optical semiconductor light emitting device has recently expanded and an increase in the luminance of the optical semiconductor light emitting device has proceeded, and thus, human bodies are exposed to blue light in many cases.

However, in a view that the light scattering composite of the present invention is used in the light scattering conversion layer or the light scattering layer of the white optical semiconductor light emitting device (the light scattering conversion layer or the light scattering layer of the white optical semiconductor light emitting device is formed using the composition for forming a light scattering composite of the present invention), the luminance can be enhanced by reducing blue light components, emitted together with white light. In addition, color rendering properties can also be enhanced by reducing the blue light components.

Examples of the combination of the optical semiconductor light emitting element with the phosphor in the optical semiconductor light emitting device include a combination of a blue optical semiconductor light emitting element in the vicinity of a light emitting wavelength of 460 nm with a yellow phosphor; a combination of a blue optical semiconductor light emitting element in the vicinity of a light emitting wavelength of 460 nm with a red phosphor and a green phosphor; and a combination of a near-ultraviolet optical semiconductor light emitting element in the vicinity of a light emitting wavelength of 340 nm or more and 410 nm or less with three primary-color phosphors of a red phosphor, a green phosphor, and a blue phosphor. As for various optical semiconductor light emitting elements and various phosphors in this case, known ones can be used.

Furthermore, as a sealing resin for sealing various optical semiconductor light emitting elements and various phosphors, known ones can be used.

In addition, in the following description, light having each of the light emitting wavelengths, emitted by the optical semiconductor light emitting element used in the combination of the optical semiconductor light emitting element and the phosphor may be referred to as the "luminous light components" of an optical semiconductor light emitting element in some cases . Further, light emitted by the phosphor upon irradiating the phosphor with the luminous light components, that is, light in which the color of light emitted component has been wavelength-converted by the phosphor may be referred to as the "converted light component" from the phosphor in some cases.

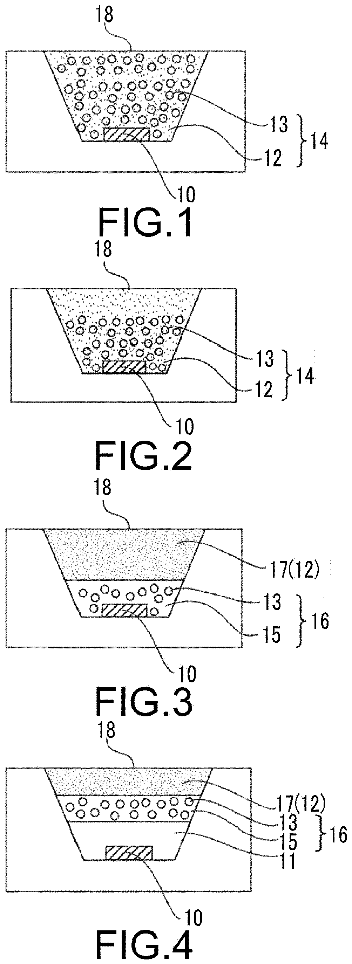

Aspects on optical semiconductor light emitting devices A and B are described with reference to FIGS. 1 to 4.

First, in a first aspect of the optical semiconductor light emitting device A, an optical semiconductor light emitting element 10 is disposed in the concave portion of the substrate as shown in FIG. 1, and so as to cover this, a light scattering conversion layer 14 having phosphor particles 13 in a light scattering composite 12 including light scattering particles and a matrix resin is provided. Here, the light scattering particles may be uniformly present in the matrix resin, but are preferably present in an even more amount on the side of an outside air phase interface (interface with the outside air layer) 18. By making even more light scattering particles be present on the side of the outside air phase interface 18, most of the blue light components which have passed between the phosphor particles 13 and have not been irradiated onto the phosphor particles 13 can be scattered, and thus returned to the phosphor particles 13. Therefore, the blue light components emitted together with white light can be reduced, thereby further enhancing the luminance.

In addition, in any of the optical semiconductor light emitting devices including the following configuration, there is no particular limitation in the surface shape of the outside air phase interface 18, and may be any one of a flat shape, a convex shape, and a concave shape.

In a second aspect of the optical semiconductor light emitting device A, by making the phosphor particles 13 in the light scattering conversion layer 14 be further present in the vicinity of the optical semiconductor light emitting element 10, as compared with the case of FIG. 1, as shown in FIG. 2, the light scattering particles are thus present on the side of the outside air phase interface 18 more than on the side of the phosphor particle. By adopting such an aspect, most of the blue light components which have passed through the region in which the phosphor particles 13 are present can be scattered and returned to the region in which the phosphor particles 13 are present. Therefore, the blue light components emitted together with white light can be reduced, thereby further enhancing the luminance.

The optical semiconductor light emitting device B is an aspect in which a layer including phosphor particles (light conversion layer) and a layer including light scattering particles (light scattering layer) are dividedly disposed. A first aspect of the optical semiconductor light emitting device B is that an optical semiconductor light emitting element 10 is disposed in the concave portion of a substrate, and so as to cover this, a light conversion layer 16 having phosphor particles 13 in a matrix material 15, and a light scattering layer 17 including a light scattering composite 12 containing light scattering particles and a matrix resin is provided on the light conversion layer 16, that is, on the side of the outside air phase interface 18 of the light conversion layer 16, as shown in FIG. 3.

By adopting such an aspect, most of the blue light components which have passed through the light conversion layer 16 can be scattered by the light scattering layer 17 and returned to the light conversion layer 16. Therefore, the blue light components emitted together with white light can be reduced, thereby further enhancing the luminance.

In a second aspect of the optical semiconductor light emitting device B, a sealing resin layer 11 including a sealing resin is provided so as to cover the optical semiconductor light emitting element 10, and a light conversion layer 16 and a light scattering layer 17 are sequentially laminated on the sealing resin layer 11, as shown in FIG. 4.

In the optical semiconductor light emitting device B, the thickness of the light conversion layer and the light scattering layer is not particularly limited as long as the effect of the present invention is obtained, but in a case where it is desired to further reduce the blue components, it is preferable to further increase the thickness of the light scattering layer, and the thickness of the light scattering layer may be designed depending on the wavelength conversion efficiency and the addition amount of the phosphor to be used in a case of adjusting the optical semiconductor light emitting device to desired color rendering properties.

A content of the light scattering particle is 0.01% by mass or more and 15% by mass or less with respect to a total amount of the light scattering conversion layer in the optical semiconductor light emitting device A; and is 0.01% by mass or more and 15% by mass or less with respect to a total amount of the light scattering layer in optical semiconductor light emitting device B. The content of the light scattering particle in the light conversion layer or the light scattering layer is preferably 0.01% by mass or more and 10% by mass or less, and more preferably 0.1% by mass or more and 5% by mass or less.

If the content of the light scattering particles in each of the layers is more than 15% by mass, the amount of the light scattering particles is excessively large, in particular, the amount of the associated particles having large particle diameters and having a high light scattering ability is increased. Therefore, the scattering becomes excessively significant, not only the color of light emitted components from the optical semiconductor light emitting element, but also the converted light components from the phosphor do not come to the outside air phase, and the luminance of the optical semiconductor light emitting device is reduced. On the other hand, in the content of the light scattering particles in each of the layers is less than 0.01% by mass, the amount of the light scattering particles is excessively small, a light scattering effect is not obtained, and enhancement of the luminance of the optical semiconductor light emitting device cannot be facilitated. That is, by setting the content of the light scattering particles in each of the layers to 0.01% by mass or more and 15% by mass or less, the balance between the light scattering properties of the color of light emitted components from optical semiconductor light emitting element, and the light transmitting properties of a combination of the color of light emitted components and the converted light components in each of the layers is good, and a high-luminance optical semiconductor light emitting device can be obtained.

Furthermore, by setting the content of the light scattering particles in each of the layers to 0.01% by mass or more and 15% by mass or less, the scattering rate of blue light can be increased. That is, the value of the integrated transmittance in light at a wavelength of 460 nm can be increased to be higher than the value of the linear transmittance. Further, for example, a difference between the two values (the integrated transmittance - the linear transmittance) can be set to 25 points or more, or up to 40 points or more. Thus, reduction in blue light in the optical semiconductor light emitting device and enhancement of luminance can be facilitated.

The optical semiconductor light emitting device is prepared by applying or injecting the composition for forming a light scattering composite of the present invention onto or into a light conversion layer, or mixing phosphor particles in a composition for forming a light scattering composite and applying or injecting them onto or into an optical semiconductor light emitting element, followed by curing.

For example, an optical semiconductor light emitting device B is prepared by applying or injecting the composition for forming a light scattering composite of the present invention onto or into a light conversion layer, followed by curing, thereby forming a light scattering layer including the light scattering composite. Alternatively, an optical semiconductor light emitting device A is prepared by mixing the phosphor particles in the composition for forming a light scattering composite, applying or injecting the mixture onto or into the optical semiconductor light emitting element, followed by curing, thereby forming a light scattering conversion layer including the phosphor-containing light scattering composite. A method for curing the composition for forming a light scattering composite of the present invention is not particularly limited, and examples thereof include polymerization curing reactions by an addition-type reaction, a fusion-type reaction, a radical polymerization reaction, or the like. The polymerization reaction can be carried out by heating, application of external energy, such as light irradiation, addition of a catalyst (polymerization agent), or the like.

During curing, at least some of the surface-modified inorganic oxide particles (dispersed particles) dispersed in the composition for forming a light scattering composite are associated to form associated particles in the matrix resin.

Formation of the associated particles can be accomplished by controlling the affinity between the matrix resin (composition) and the surface-modified inorganic oxide particles as described above. That is, the controls may be performed in the following manners, for example: (1) a surface modification material having one or more functional groups selected from an alkenyl group, an H-Si group, and an alkoxy group is used as the surface modification material in the surface-modified inorganic oxide particles, (2) the surface modification amount is set to 1% by mass or more and 50% by mass or less, (3) a polymer-type surface modification material and an oligomer-type surface modification material are appropriately used, and the molecular weight of the polymer-type surface modification material and the molecular weight of the oligomer-type surface modification material are each set to 0.1 to 50 times the molecular weight of the matrix resin, and (4) the treatment amounts of the polymer-type surface modification material and the oligomer-type surface modification material may be controlled to be 0.1% by mass or more and 10% by mass or less with respect to the mass of the inorganic oxide particles. By controlling these, with regard to the affinity between the matrix resin (composition) and the surface-modified inorganic oxide particles, formation of appropriate associated particles can be accomplished by relatively increasing the interaction properties among the surface-modified inorganic oxide particles.

In addition, by lowering the curing rate of the light scattering composition, and maintaining the state where the surface-modified inorganic oxide particles in the light scattering composition during curing can move, one or both of a cohesive force among the inorganic oxide particles and a repulsive force of the other components in the matrix resin are used, the degree of association of the inorganic oxide particles is increased, and appropriate associated particles may be formed.

It is preferable that the particle diameters of the associated particles thus formed are 1,200 nm or less. In addition, an average particle diameter of all particles formed by combination of the associated particles and the dispersed particles maintained in the non-associated state, that is, the average particle diameter of the light scattering particles is preferably 10 nm or more and 1,000 nm or less, more preferably 20 nm or more and 1,000 nm or less, and still more preferably 50 nm or more and 800 nm or less.

In addition, a method for measuring the average particle diameter of the light scattering particles is as described above.

Furthermore, in the above description, an optical semiconductor light emitting device prepared by applying or injecting the composition for forming a light scattering composite of the present invention onto or into a light conversion layer, or mixing phosphor particles in a composition for forming a light scattering composite and applying or injecting them onto or into an optical semiconductor light emitting element, followed by curing, is shown. However, the configuration or the preparation method for the optical semiconductor light emitting device is not limited thereto.

For example, the light scattering composite of the present invention, which has been molded into a sheet shape in advance, may be attached onto an approximately flat plane-shaped element configured such that an optical semiconductor light emitting element is disposed on a substrate, and a light conversion layer is formed thereon. In addition, phosphor particles may be mixed with the composition for forming a light scattering composite of the present invention, followed by curing it into a sheet shape, and the product may be attached onto an optical semiconductor light emitting element disposed on a substrate.

[Illumination Apparatus and Display Device]

The optical semiconductor light emitting device of the present invention may be employed for various uses due to its excellent properties. The effect of the present invention is particularly significantly recognized in various illumination apparatuses and display devices, each including the optical semiconductor light emitting device.

Examples of the illumination apparatus include general illumination apparatuses such as indoor lighting and outdoor lighting. In addition, the optical semiconductor light emitting device may also be applied to illumination of a switch unit of an electronic apparatus such as a mobile phone and office automation (OA) equipment.

Examples of the display device include light emitting devices in display devices of instruments which particularly require high luminance and good color rendering properties while achieving a size reduction, a weight reduction, a thickness reduction, power savings, and good visibility even under sunlight, such as a mobile phone, a portable information terminal, an electronic dictionary, a digital camera, a computer, a thin television, illumination equipment, and peripheral devices thereof. In particular, a display device which is viewed over a long period of time such as the display device (display) of a computer or a thin television is particularly appropriate since an effect on human bodies, particularly on the eyes, can be suppressed. In addition, since a reduction in size can be achieved by causing the distance between a first light emitting element and a second light emitting element to be 3 mm or less, or to be close to 1 mm or less, a small display device having a 15-inch or less size is also appropriate.

EXAMPLES

Various measurement methods and evaluation methods according to the present Examples are as follows.

(Surface Modification Amount of Surface-Modified Inorganic Oxide Particles in Dispersion Liquid)

The surface modification amount in the surface-modified inorganic oxide particles was calculated, based on the measurement by means of thermogravimetric analysis. As described later, the surface-modified inorganic oxide particles extracted from the dispersion liquid of the surface-modified inorganic oxide particles was dried by an evaporator and the dispersion medium was removed, thereby preparing a sample. The obtained sample was subjected to thermogravimetric analysis to measure a weight reduction from 115°C to 500°C. Further, the weight reduction of lower than 115°C was due to the dispersion medium (toluene) which had remained. The surface modification amount was calculated, based on the obtained weight reduction from 115°C to 500°C, and a content of the volatile components (C, H, O, and N) in the surface modification material and a content of the nonvolatile components (Si).

(Measurement of Integrated Transmittance of Composition for Forming Light Scattering Composite)

The integrated transmittance of the composition for forming a light scattering composite was measured by interposing the composition for forming a light scattering composite between thin layer quartz cells having a size of 1.0 mm as a sample, and using an integrating sphere by a spectrophotometer (V-570 manufactured by JASCO Corporation). A transmittance of 40% or more and 95% or less at a wavelength (λ) of 460 nm, and a transmittance of 75% or more at a wavelength (λ) of 550 nm were evaluated as "Good", and a transmittance outside the ranges was evaluated as "Poor".

In addition, the thin layer quartz cells having the composition for forming a light scattering composite interposed therebetween were installed instead of the reflector of the spectrophotometer, a reflection spectrum which had returned from the integrating sphere was measured, and it was seen that a reduction in transmittance at short wavelengths corresponded to an increase in reflectance. From this, it was found that absorption of light by particles did not occur and backscattering by particles had occurred.

(Measurement of Transmittance of Light Scattering Composite: Comparison of Integrated Transmittance and Linear Transmittance)

The transmittance of the light scattering composite was measured by using a light scattering composite molded in a substrate shape having a thickness of 1 mm as a sample, and carrying out integrating sphere measurement and linear measurement by a spectrophotometer (V-570 manufactured by JASCO Corporation). Thus, the integrated transmittance and the linear transmittance at a wavelength of 460 nm and 550 nm were determined.

In addition, as described above, the "integrated transmittance" is a "transmittance measured with an integrating sphere", and the "linear transmittance" is a "transmittance measured with linear light which is a general transmittance measuring method".

(Measurement of Average Primary Particle Diameter of Inorganic Oxide Particles)

The average primary particle diameter of the inorganic oxide particles was evaluated as a Scherrer diameter obtained by X-ray diffraction.

(Measurement of Average Dispersed Particle Diameter in Composition for Forming Light Scattering Composite)

The average dispersed particle diameter of the surface-modified inorganic oxide particles in the composition for forming a light scattering composite was determined by means of a particle size distribution measuring apparatus (Nano Partica SZ-100 manufactured by Horiba, Ltd.) having a dynamic light scattering method as a measurement principle, using the composition for forming a light scattering composite. From the results of particle size distribution of the surface-modified inorganic oxide particles obtained by the measurement, a volume-average particle diameter (MV value) was determined, and the value was defined as an average dispersed particle diameter.

(Dispersion State of Light Scattering Particles in Light Scattering Composite)

The dispersion state of the light scattering particles in the light scattering composite was evaluated by carrying out an integrating sphere measurement at a wavelength of 460 nm, using a measurement sample by a spectrophotometer (V-570 manufactured by JASCO Corporation), and determining the integrated transmittance. As the measurement sample, a sample in which a light scattering composite molded into a substrate shape having a thickness of 1 mm had been bisected on the surface side and the back surface side, and then the thickness of both samples had been adjusted to the same was used. Then, if a difference in the integrated transmittance at both samples was within 10%, the dispersion state was defined to be uniform, whereas if the difference was more than 10%, the dispersion state was defined to be nonuniform.

(Measurement of Average Particle Diameter of Light Scattering Particles in Light Scattering Composite)

The average particle diameter of the light scattering particles in the light scattering composite was determined by using a light scattering composite which had been flaked in the thickness direction as a sample, observing the sample with an electrolytic-emission transmission electron microscope (JEM-2100F manufactured by JEOL Ltd.), measuring the particle diameters of 50 arbitrary light scattering particles, and calculating an average value thereof.

Here, the light scattering particles were defined as follows. That is, with regard to the surface-modified inorganic oxide particles which are present individually (without association), the particles themselves were taken as one of the light scattering particles, and their particle diameters were defined as light scattering particle diameters. Further, in a case where a plurality of light scattering particles are overlapped or observed to be continuous, the plurality of particles as a whole were taken as one of the light scattering particles (associated particles), and the particle diameters of the entire parts determined as the light scattering particles were taken as the particle diameters of the light scattering particles.

(Evaluation of Light Emission Spectrum of Optical Semiconductor Light Emitting Device)

The light emission spectrum of the optical semiconductor light emitting device was measured by using a spectral measurement apparatus (PMA-12 manufactured by Hamamatsu Photonics K. K.). Here, when a light emission spectrum peak area at a wavelength of 400 nm to 480 nm was represented by a, a light emission spectrum peak area at a wavelength of 480 nm to a wavelength of 800 nm was represented by b, and thus, evaluation was carried out with the value of a/b. Based on Comparative Examples 1 and 2, not containing light scattering particles, in Examples 1 to 16, 19, 21, and 22, and Comparative Examples 3 to 7, the value of a/b which was less than a/b of Comparative Example 1 was evaluated to be "Good", and the same value or more was evaluated to be "Poor". In Examples 17, 18, and 20, and Comparative Example 8, the values were compared with the value of a/b of Comparative Example 2.

(Evaluation of Luminance of Optical Semiconductor Light Emitting Device)

The luminance of the optical semiconductor light emitting device was measured by using a luminance meter (LS-110 manufactured by Konica Minolta, Inc.). Based on Comparative Examples 1 and 2 not containing the light scattering particles, in Examples 1 to 16, 19, 21, and 22, and Comparative Examples 3 to 7, a luminance which was more than that of Comparative Example 1 was evaluated to be "Good", the same value was evaluated to be "Possible", and a luminance which was less than that was evaluated to be "Poor". In Examples 17, 18, and 20, and Comparative Example 8, the luminance was compared to that of Comparative Example 2.

<Preparation of Unmodified Particles>

As the unmodified inorganic oxide particles (unmodified particles) constituting the light scattering particles, the following zirconia particles 1 to 3 and silica particles were prepared.

(Preparation of Zirconia Particles 1)

Dilute ammonia water obtained by dissolving 344 g of 28% ammonia water in 20 L (liters) of pure water was added to a zirconium salt solution obtained by dissolving 2,615 g of zirconium oxychloride octahydrate in 40 L of pure water while being stirred, thereby producing a zirconia precursor slurry.

An aqueous solution of sodium sulfate obtained by dissolving 300 g of sodium sulfate in 5 L of pure water was added to the slurry while being stirred, thereby obtaining a mixture. The amount of sodium sulfate added at this time was 30% by mass with respect to the equivalent zirconia value of zirconium ions in the zirconium salt solution.

The mixture was dried in the air at 130°C for 24 hours by using a dryer, thereby obtaining a solid matter. The solid matter was crushed by an automatic mortar, and was then baked in the air at 520°C for 1 hour by using an electric furnace.

Subsequently, the calcined product was introduced into pure water, stirred to be in a slurry form, and then washed using a centrifugal separator to remove the added sodium sulfate sufficiently using a centrifugal separator. Thereafter, the resultant was dried by a dryer, thereby obtaining zirconia particles 1. The average primary particle diameter of the zirconia particles 1 was 5.5 nm.

(Preparation of Zirconia Particles 2)

Zirconia particles 2 were prepared in the same manner as in the preparation of the zirconia particles 1 except that the calcination temperature in the electric furnace in the preparation of the zirconia particles 1 was changed from 520°C to 500°C. The average primary particle diameter of the zirconia particles 2 was 2.1 nm.

(Preparation of Zirconia Particles 3)

Zirconia particles 3 were prepared in the same manner as in the preparation of the zirconia particles 1 except that the calcination temperature in the electric furnace in the preparation of the zirconia particles 1 was changed from 520°C to 650°C. The average primary particle diameter of the zirconia particles 3 was 42.1 nm.

(Preparation of Silica Particles)

Silica particles containing silica sol (SNOWTEX OS manufactured by Nissan Chemical Industries, Ltd., 20% by mass in terms of $SiO_2$) were used as they were. Further, actual measurements were carried out using dry powder containing silica particles which will be described later, in a view that X-ray diffraction measurement cannot be carried out in a sol state, and handling in the measurement was inconvenient in a case of simply drying and solidifying the sol. The average primary particle diameter was 9.5 nm.

<Preparation of Surface-Modified Zirconia Dispersion Liquid>

(Preparation of Surface-Modified Zirconia Particle Dispersion Liquid 1)

86 g of toluene and 2 g of a methoxy group-containing methylphenyl silicone resin (KR9218 manufactured by Shin-Etsu Chemical Co., Ltd.) were added to 10 g of the zirconia particles 1, mixed with each other, and stirred for 6 hours with a bead mill to carry out a surface modification treatment, and then the beads were removed. Subsequently, 2 g of vinyl trimethoxysilane (KBM1003 manufactured by Shin-Etsu Chemical Co., Ltd.) as an alkenyl group (vinyl group) -containing surface modification material was added thereto, and the mixture was subjected to modification and dispersion under reflux at 130°C for 8 hours. The obtained dispersion liquid was centrifuged to remove the supernatant, and centrifuged again by addition of toluene to extract the surface-modified zirconia particles, thereby obtaining surface-modified zirconia particles in which toluene (dispersion medium), the methoxy group-containing methylphenyl silicone resin remaining in the dispersion medium and not modifying zirconia particles, and the vinyl trimethoxysilane (surface modification material) remaining in the dispersion medium and not modifying zirconia particles were removed. Some of the obtained surface-modified zirconia particles were taken, a surface modification amount thereof was measured, and then, re-dispersion was carried out again by addition of toluene to the residue to reach 10% by mass in terms of zirconia particles, thereby preparing a surface-modified zirconia particle dispersion liquid 1.

The obtained surface-modified zirconia particle dispersion liquid 1 was transparent. Further, the surface modification amount by the surface modification material in the surface-modified zirconia particles was 40% by mass with respect to the mass of the zirconia particles. Accordingly, the amount of the surface-modified zirconia particles in the surface-modified zirconia particle dispersion liquid was 14% by mass. In addition, the mass ratio of the methoxy group-containing methylphenyl silicone resin to vinyl trimethoxysilane was 1 to 1.

(Preparation of Surface-Modified Zirconia Particle Dispersion Liquid 2)

A surface-modified zirconia particle dispersion liquid 2 was prepared in the same manner as for the surface-modified zirconia particle dispersion liquid 1 except that the stirring time in the bead mill after addition of the methoxy group-containing methylphenyl silicone resin was 2 hours and the reflux time after addition of vinyl trimethoxysilane was 3 hours in the preparation of the surface-modified zirconia particle dispersion liquid 1.

The obtained surface-modified zirconia particle dispersion liquid 2 was transparent. Further, the surface modification amount by the surface modification material in the surface-modified zirconia particles was 40% by mass with respect to the mass of the zirconia particles. Accordingly, the amount of the surface-modified zirconia particles in the surface-modified zirconia particle dispersion liquid was 14% by mass. In addition, the mass ratio of the methoxy group-containing methylphenyl silicone resin to vinyl trimethoxysilane was 1 to 1.

(Preparation of Surface-Modified Zirconia Particle Dispersion Liquid 3)

A surface-modified zirconia particle dispersion liquid 3 was prepared in the same manner as for the surface-modified zirconia particle dispersion liquid 1 except that the stirring time in the bead mill after addition of the methoxy group-containing methylphenyl silicone resin was 0.5 hours and the reflux time after addition of vinyl trimethoxysilane was 0.5 hours in the preparation of the surface-modified zirconia particle dispersion liquid 1.

The obtained surface-modified zirconia particle dispersion liquid 3 was slightly white turbid. Further, the surface modification amount by the surface modification material in the surface-modified zirconia particles was 25% by mass with respect to the mass of the zirconia particles. Accordingly, the amount of the surface-modified zirconia particles in the surface-modified zirconia particle dispersion liquid was 12.5% by mass. In addition, the mass ratio of the methoxy group-containing methylphenyl silicone resin to vinyl trimethoxysilane was 1 to 1.

(Preparation of Surface-Modified Zirconia Particle Dispersion Liquid 4)

A surface-modified zirconia particle dispersion liquid 4 was prepared in the same manner as for the surface-modified zirconia particle dispersion liquid 1 except that the zirconia particles 2 were used as the inorganic oxide particles, the stirring time in the bead mill after addition of the methoxy group-containing methylphenyl silicone resin was 2 hours and the reflux time after addition of vinyl trimethoxysilane was 3 hours in the preparation of the surface-modified zirconia particle dispersion liquid 1.

The obtained surface-modified zirconia particle dispersion liquid 4 was transparent. Further, the surface modification amount by the surface modification material in the surface-modified zirconia particles in the surface-modified zirconia particle dispersion liquid 4 was 40% by mass with respect to the mass of the zirconia particles. Accordingly, the amount of the surface-modified zirconia particles in the surface-modified zirconia particle dispersion liquid was 14% by mass. In addition, the mass ratio of the methoxy group-containing methylphenyl silicone resin to vinyl trimethoxysilane was 1 to 1.

(Preparation of Surface-Modified Zirconia Particle Dispersion Liquid 5)

A surface-modified zirconia particle dispersion liquid 5 was prepared in the same manner as for the surface-modified zirconia particle dispersion liquid 1 except that the zirconia particles 2 were used as the inorganic oxide particles, the stirring time in the bead mill after addition of the methoxy group-containing methylphenyl silicone resin was 0.5 hours and the reflux time after addition of vinyl trimethoxysilane was 0.5 hours in the preparation of the surface-modified zirconia particle dispersion liquid 1.

The obtained surface-modified zirconia particle dispersion liquid 5 was approximately transparent. Further, the surface modification amount by the surface modification material in the surface-modified zirconia particles in the surface-modified zirconia particle dispersion liquid 5 was 30% by mass with respect to the mass of the zirconia particles. Accordingly, the amount of the surface-modified zirconia particles in the surface-modified zirconia particle dispersion liquid was 13% by mass. In addition, the mass ratio of the methoxy group-containing methylphenyl silicone resin to vinyl trimethoxysilane was 1 to 1.

(Preparation of Surface-Modified Zirconia Particle Dispersion Liquid 6)

A surface-modified zirconia particle dispersion liquid 6 was prepared in the same manner as for the surface-modified zirconia particle dispersion liquid 1 except that the zirconia particles 3 were used as the inorganic oxide particles in the preparation of the surface-modified zirconia particle dispersion liquid 1.

The obtained surface-modified zirconia particle dispersion liquid 6 was slightly white turbid. Further, the surface modification amount by the surface modification material in the surface-modified zirconia particles in the surface-modified zirconia particle dispersion liquid 6 was 40% by mass with respect to the mass of the zirconia particles. Accordingly, the amount of the surface-modified zirconia particles in the surface-modified zirconia particle dispersion liquid was 14% by mass. In addition, the mass ratio of the methoxy group-containing methylphenyl silicone resin to vinyl trimethoxysilane was 1 to 1.

(Preparation of Surface-Modified Zirconia Particle Dispersion Liquid 7)

A surface-modified zirconia particle dispersion liquid 7 was prepared in the same manner as for the surface-modified zirconia particle dispersion liquid 1 except that the zirconia particles 3 were used as the inorganic oxide particles, the stirring time in the bead mill after addition of the methoxy group-containing methylphenyl silicone resin was 2 hours and the reflux time after addition of vinyl trimethoxysilane was 3 hours in the preparation of the surface-modified zirconia particle dispersion liquid 1.

The obtained surface-modified zirconia particle dispersion liquid 7 was white turbid. Further, the surface modification amount by the surface modification material in the surface-modified zirconia particles in the surface-modified zirconia particle dispersion liquid 7 was 35% by mass with respect to the mass of the zirconia particles. Accordingly, the amount of the surface-modified zirconia particles in the surface-modified zirconia particle dispersion liquid was 13.5% by mass. In addition, the mass ratio of the methoxy group-containing methylphenyl silicone resin to vinyl trimethoxysilane was 1 to 1.

(Preparation of Surface-Modified Silica Particle Dispersion Liquid 8)

50 g of a methanol solution having 5 g of hexanoic acid dissolved therein was mixed with 50 g of a silica sol (SNOWTEX OS manufactured by Nissan Chemical Industries, Ltd., 20% by mass in terms of $SiO_2$) under stirring to obtain a slurry. The obtained slurry was centrifuged to remove the supernatant, and then centrifuged again by addition of methanol to remove the supernatant, and excess hexanoic acid was removed. Then, the solvent of the settling materials was dried and removed by an evaporator to obtain a dry powder containing silica particles. 10 g of the obtained dry powder containing silica particles was mixed with 85 g of toluene. Then, 2.5 g of an epoxy-modified silicone having one end (X-22-173DX manufactured by Shin-Etsu Chemical Co., Ltd.) and 2.5 g of vinyl trimethoxysilane (KBM1003 manufactured by Shin-Etsu Chemical Co. , Ltd.) as an alkenyl group (vinyl group)-containing surface modification material were added thereto to carry out surface modification and dispersion under reflux at 130°C for 6 hours. 100 g of methanol was introduced into 100 g of the obtained silica particle dispersion liquid, and the obtained settling materials were recovered, washed with methanol, and dried. Some of the obtained surface-modified silica particles were taken and a surface modification amount thereof was measured. Then, toluene was added to the residue and re-dispersed to a concentration of 10% by mass in terms of silica particles, thereby preparing a surface-modified silica particle dispersion liquid 8.

The obtained surface-modified silica particle dispersion liquid 8 was transparent. Further, the surface modification amount by the surface modification material in the surface-modified silica particles was 40% by mass with respect to the mass of the silica particles. Accordingly, the amount of the surface-modified silica particles in the surface-modified silica particle dispersion liquid was 14% by mass. In addition, the mass ratio of the epoxy-modified silicone having one end to vinyl trimethoxysilane was 1 to 1.

(Preparation of Surface-Modified Silica Particle Dispersion Liquid 9)

A surface-modified silica particle dispersion liquid 9 was prepared in the same manner as for the surface-modified silica particle dispersion liquid 8 except that the reflux time after addition of epoxy-modified silicone having one end and vinyl trimethoxysilane was 3 hours in the preparation of the surface-modified zirconia particle dispersion liquid 8.

The obtained surface-modified silica particle dispersion liquid 9 was transparent. Further, the surface modification amount by the surface modification material in the surface-modified silica particles was 40% by mass with respect to the mass of the silica particles. Accordingly, the amount of the surface-modified silica particles in the surface-modified silica particle dispersion liquid was 14% by mass. In addition, the mass ratio of the epoxy-modified silicone having one end to vinyl trimethoxysilane was 1 to 1.

(Preparation of Surface-Modified Zirconia Particle Dispersion Liquid 10)

A surface-modified zirconia particle dispersion liquid 10 was prepared in the same manner as for the surface-modified zirconia particle dispersion liquid 1 except that methyldichlorosilane (LS-50 manufactured by Shin-Etsu Chemical Co., Ltd.) which is an H-Si group-containing surface modification material was used instead of the alkenyl group-containing surface modification material, the stirring time in the bead mill after addition of the methoxy group-containing methylphenyl silicone resin was 2 hours and the reflux time after addition of methyldichlorosilane was 2 hours in the preparation of the surface-modified zirconia particle dispersion liquid 1.

The obtained surface-modified zirconia particle dispersion liquid 10 was transparent. Further, the surface modification amount by the surface modification material in the surface-modified zirconia particles in the surface-modified zirconia particle dispersion liquid 10 was 40% by mass with respect to the mass of the zirconia particles. Accordingly, the amount of the surface-modified zirconia particles in the surface-modified zirconia particle dispersion liquid was 14% by mass. In addition, the mass ratio of the methoxy group-containing methylphenyl silicone resin to methyldichlorosilane was 1 to 1.

(Preparation of Surface-Modified Zirconia Particle Dispersion Liquid 11)

A surface-modified zirconia particle dispersion liquid 11 was prepared in the same manner as for the surface-modified zirconia particle dispersion liquid 1 except that tetraethoxysilane (KBE-04 manufactured by Shin-Etsu Chemical Co., Ltd.) which is an alkoxy group-containing surface modification material was used instead of the alkenyl group-containing surface modification material, the stirring time in the bead mill after addition of the methoxy group-containing methylphenyl silicone resin was 2 hours and the reflux time after addition of tetraethoxysilane was 2 hours in the preparation of the surface-modified zirconia particle dispersion liquid 1.

The obtained surface-modified zirconia particle dispersion liquid 11 was transparent. Further, the surface modification amount by the surface modification material in the surface-modified zirconia particles in the surface-modified zirconia particle dispersion liquid 11 was 40% by mass with respect to the mass of the zirconia particles. Accordingly, the amount of the surface-modified zirconia particles in the surface-modified zirconia particle dispersion liquid was 14% by mass. In addition, the mass ratio of the methoxy group-containing methylphenyl silicone resin to tetraethoxysilane was 1 to 1.

(Preparation of Surface-Modified Zirconia Particle Dispersion Liquid 12)

A surface-modified zirconia particle dispersion liquid 12 was prepared in the same manner as for the surface-modified zirconia particle dispersion liquid 1 except that the zirconia particles 2 were used as the inorganic oxide particles, the amount of toluene was 89 g, the amount of the methoxy group-containing methylphenyl silicone resin was 0.5 g, and the amount of the vinyl trimethoxysilane was 0.5 g in the preparation of the surface-modified zirconia particle dispersion liquid 1.

The obtained surface-modified zirconia particle dispersion liquid 12 was transparent. Further, the surface modification amount by the surface modification material in the surface-modified zirconia particles was 10% by mass with respect to the mass of the zirconia particles. Accordingly, the amount of the surface-modified zirconia particles in the surface-modified zirconia particle dispersion liquid was 11% by mass. In addition, the mass ratio of the methoxy group-containing methylphenyl silicone resin to vinyl trimethoxysilane was 1 to 1.

(Preparation of Surface-Modified Zirconia Particle Dispersion Liquid 13)

A surface-modified zirconia particle dispersion liquid 13 was prepared in the same manner as for the surface-modified zirconia particle dispersion liquid 1 except that the amount of toluene was 82 g, the amount of the methoxy group-containing methylphenyl silicone resin was 4 g, and the amount of the vinyl trimethoxysilane was 4 g in the preparation of the surface-modified zirconia particle dispersion liquid 1.

The obtained surface-modified zirconia particle dispersion liquid 13 was transparent. Further, the surface modification amount by the surface modification material in the surface-modified zirconia particles was 80% by mass with respect to the mass of the zirconia particles. Accordingly, the amount of the surface-modified zirconia particles in the surface-modified zirconia particle dispersion liquid was 18% by mass. In addition, the mass ratio of the methoxy group-containing methylphenyl silicone resin to vinyl trimethoxysilane was 1 to 1.

(Preparation of Surface-Modified Zirconia Particle Dispersion Liquid 14)

A surface-modified zirconia particle dispersion liquid 14 was prepared in the same manner as for the surface-modified zirconia particle dispersion liquid 1 except that the zirconia particles 2 were used as the inorganic oxide particles in the preparation of the surface-modified zirconia particle dispersion liquid 1.

The obtained surface-modified zirconia particle dispersion liquid 14 was transparent. Further, the surface modification amount by the surface modification material in the surface-modified zirconia particles in the surface-modified zirconia particle dispersion liquid 14 was 40% by mass with respect to the mass of the zirconia particles. Accordingly, the amount of the surface-modified zirconia particles in the surface-modified zirconia particle dispersion liquid was 14% by mass. In addition, the mass ratio of the methoxy group-containing methylphenyl silicone resin to vinyl trimethoxysilane was 1 to 1.

(Preparation of Surface-Modified Zirconia Particle Dispersion Liquid 15)

A surface-modified zirconia particle dispersion liquid 15 was prepared in the same manner as for the surface-modified zirconia particle dispersion liquid 1 except that the zirconia particles 3 were used as the inorganic oxide particles, the stirring time in the bead mill after addition of the methoxy group-containing methylphenyl silicone resin was 0.5 hours and the reflux time after addition of the vinyl trimethoxysilane was 0.5 hours in the preparation of the surface-modified zirconia particle dispersion liquid 1.

The obtained surface-modified zirconia particle dispersion liquid 15 was white turbid, and settling of the zirconia particles occurred. Further, the surface modification amount by the surface modification material in the surface-modified zirconia particles in the surface-modified zirconia particle dispersion liquid 15 was 20% by mass with respect to the mass of the zirconia particles. Accordingly, the amount of the surface-modified zirconia particles in the surface-modified zirconia particle dispersion liquid was 12% by mass. In addition, the mass ratio of the methoxy group-containing methylphenyl silicone resin to vinyl trimethoxysilane was 1 to 1.

(Preparation of Surface-Modified Silica Particle Dispersion Liquid 16)

A surface-modified silica particle dispersion liquid 16 was prepared in the same manner as for surface-modified silica particle dispersion liquid 8 except that the reflux time after addition of the epoxy-modified silicone having one end and vinyl trimethoxysilane was 1 hour in the preparation of the surface-modified silica particle dispersion liquid 8.

The obtained surface-modified silica particle dispersion liquid 16 was white turbid. Further, the surface modification amount by the surface modification material in the surface-modified silica particles was 35% by mass with respect to the mass of the silica particles. Accordingly, the amount of the surface-modified silica particles in the surface-modified silica particle dispersion liquid was 13.5% by mass. In addition, the mass ratio of the epoxy-modified silicone having one end to vinyl trimethoxysilane was 1 to 1.

(Preparation of Surface-Modified Zirconia Particle Dispersion Liquid 17)

A surface-modified zirconia particle dispersion liquid 17 was prepared in the same manner as for the surface-modified zirconia particle dispersion liquid 1 except that stearic acid (an alkyl group-containing surface modification material) which is a saturated fatty acid was used instead of the alkenyl group-containing surface modification material, the stirring time in the bead mill after addition of the methoxy group-containing methylphenyl silicone resin was 2 hours,

and the reflux time after addition of stearic acid was 3 hours in the preparation of the surface-modified zirconia particle dispersion liquid 1. Further, since stearic acid is a saturated fatty acid and the carboxyl group is consequently used for bonds with the zirconia particles, the stearic acid after zirconia particle modification does not have a group other than the alkyl group.

The obtained surface-modified zirconia particle dispersion liquid 17 was transparent. Further, the surface modification amount by the surface modification material in the surface-modified zirconia particles in the surface-modified zirconia particle dispersion liquid 17 was 40% by mass with respect to the mass of the zirconia particles. Accordingly, the amount of the surface-modified zirconia particles in the surface-modified zirconia particle dispersion liquid was 14% by mass. In addition, the mass ratio of the methoxy group-containing methylphenyl silicone resin to stearic acid was 1 to 1.

[Example 1]

(Preparation of Composition 1 for Forming Light Scattering Composite)

98.6 g (24.65 g of a liquid A and 73.95 g of a liquid B) of a phenyl silicone resin (OE-6635 manufactured by Dow Corning Toray Co., Ltd., a refractive index of 1.54, and a blending ratio of the liquid A/the liquid B = 1/3) was added to 10 g of the surface-modified zirconia particle dispersion liquid 1, and the mixture was stirred. Thereafter, the mixture was dried under reduced pressure to remove toluene therefrom to prepare a composition 1 for forming a light scattering composite, including surface-modified zirconia particles and a phenyl silicone resin.

The transparency of the obtained composition 1 for forming a light scattering composite was visually observed and evaluated, and as a result, the composition was found to be transparent. The average dispersed particle diameter of the surface-modified zirconia particles in the composition 1 for forming a light scattering composite, and the transparency and the transmittance of the composition 1 for forming a light scattering composite were measured as described above and evaluated. The results are shown in Table 1 below.

(Preparation of Light Scattering Composite 1)

The composition 1 for forming a light scattering composite was poured into a mold in a concave shape having a depth of 1 mm, and cured by heating at 150°C for 2 hours to prepare a light scattering composite 1 having a thickness of 1 mm. The transmittance of the obtained light scattering composite 1 was measured as described above and evaluated. The results are shown in Table 2 below.

(Preparation of Optical Semiconductor Light Emitting Device 1)

10 g of a yellow phosphor (GLD(Y)-550A manufactured by GeneLite Inc.) was added to 15 g of the composition 1 for forming a light scattering composite, and then the mixture was mixed and defoamed by a rotation-revolution type mixer to obtain a phosphor-containing composition 1 for forming a light scattering composite. Subsequently, the phosphor-containing composition 1 for forming a light scattering composite was added dropwise onto a light emitting element of a package including an unsealed blue optical semiconductor light emitting element. Further, a non-phosphor-containing composition 1 for forming a light scattering composite in the same amount as that of the phosphor-containing composition 1 for forming a light scattering composite was added dropwise onto the phosphor-containing composition 1 for forming a light scattering composite. Then, the mixture was heated at 150°C for 2 hours to cure the phosphor-containing composition 1 for forming a light scattering composite and the non-phosphor-containing composition 1 for forming a light scattering composite. As a result, an optical semiconductor light emitting device 1 of Example 1, in which a light scattering conversion layer including the light scattering particles and the phosphor and having the phosphor particles present in the vicinity of the optical semiconductor light emitting element was formed on the optical semiconductor light emitting element, was prepared.

In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer.

The light emission spectrum and the luminance of the obtained optical semiconductor light emitting device 1 were measured as described above and evaluated. The results are shown in Table 2 below.

[Example 2]

A composition 2 for forming a light scattering composite, a light scattering composite 2, and an optical semiconductor light emitting device 2 were prepared in the same manner as in Example 1 except that the surface-modified zirconia particle dispersion liquid 2 was used, respectively, instead of the surface-modified zirconia particle dispersion liquid 1 in the preparation of the composition for forming a light scattering composite, the light scattering composite, and the optical semiconductor light emitting device of Example 1.

With regard to the composition 2 for forming a light scattering composite, the light scattering composite 2, and the optical semiconductor light emitting device 2, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 3]

A composition 3 for forming a light scattering composite 3, a light scattering composite, and an optical semiconductor light emitting device 3 were prepared in the same manner as in Example 1 except that the surface-modified zirconia particle dispersion liquid 3 was used, respectively, instead of the surface-modified zirconia particle dispersion liquid 1 and the amount of the phenyl silicone resin was 98.75 g (24.69 g of the liquid A and 74.06 g of the liquid B) in the preparation of the composition for forming a light scattering composite, the light scattering composite, and the optical semiconductor light emitting device of Example 1.

With regard to the composition 3 for forming a light scattering composite, the light scattering composite 3, and the optical semiconductor light emitting device 3, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 4]

A composition 4 for forming a light scattering composite, a light scattering composite 4, and an optical semiconductor light emitting device 4 were prepared in the same manner as in Example 1 except that the surface-modified zirconia particle dispersion liquid 4 was used, respectively, instead of the surface-modified zirconia particle dispersion liquid 1 in the preparation of the composition for forming a light scattering composite, the light scattering composite, and the optical semiconductor light emitting device of Example 1.

With regard to the composition 4 for forming a light scattering composite, the light scattering composite 4, and the optical semiconductor light emitting device 4, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 5]

A composition 5 for forming a light scattering composite, a light scattering composite 5, and an optical semiconductor light emitting device 5 were prepared in the same manner as in Example 1 except that the surface-modified zirconia particle dispersion liquid 5 was used, respectively, instead of the surface-modified zirconia particle dispersion liquid 1 and the amount of the phenyl silicone resin was 98.7 g (24.68 g of the liquid A and 74.02 g of the liquid B) in the preparation of the composition for forming a light scattering composite, the light scattering composite, and the optical semiconductor light emitting device of Example 1.

With regard to the composition 5 for forming a light scattering composite, the light scattering composite 5, and the optical semiconductor light emitting device 5, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 6]

A composition 6 for forming a light scattering composite, a light scattering composite 6, and an optical semiconductor light emitting device 6 were prepared in the same manner as in Example 1 except that the surface-modified zirconia particle dispersion liquid 6 was used, respectively, instead of the surface-modified zirconia particle dispersion liquid 1 in the preparation of the composition for forming a light scattering composite, the light scattering composite, and the optical semiconductor light emitting device of Example 1.

With regard to the composition 6 for forming a light scattering composite, the light scattering composite 6, and the optical semiconductor light emitting device 6, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 7]

A composition 7 for forming a light scattering composite 7, a light scattering composite, and an optical semiconductor light emitting device 7 were prepared in the same manner as in Example 1 except that the surface-modified zirconia particle dispersion liquid 7 was used, respectively, instead of the surface-modified zirconia particle dispersion liquid 1 and the amount of the phenyl silicone resin was 98.65 g (24.66 g of the liquid A and 73.99 g of the liquid B) in the preparation of the composition for forming a light scattering composite, the light scattering composite, and the optical semiconductor light emitting device of Example 1.

With regard to the composition 7 for forming a light scattering composite, the light scattering composite 7, and the optical semiconductor light emitting device 7, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 8]

A composition 8 for forming a light scattering composite, a light scattering composite 8, and an optical semiconductor light emitting device 8 were prepared in the same manner as in Example 1 except that the surface-modified silica particle dispersion liquid 8 was used, respectively, instead of the surface-modified zirconia particle dispersion liquid 1 in the preparation of the composition for forming a light scattering composite, the light scattering composite, and the optical semiconductor light emitting device of Example 1.

With regard to the composition 8 for forming a light scattering composite, the light scattering composite 8, and the optical semiconductor light emitting device 8, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 9]

A composition 9 for forming a light scattering composite, a light scattering composite 9, and an optical semiconductor light emitting device 9 were prepared in the same manner as in Example 1 except that the surface-modified silica particle dispersion liquid 9 was used, respectively, instead of the surface-modified zirconia particle dispersion liquid 1 in the preparation of the composition for forming a light scattering composite, the light scattering composite, and the optical semiconductor light emitting device of Example 1.

With regard to the composition 9 for forming a light scattering composite, the light scattering composite 9, and the optical semiconductor light emitting device 9, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 10]

A composition 10 for forming a light scattering composite, a light scattering composite 10, and an optical semiconductor light emitting device 10 were prepared in the same manner as in Example 1 except that the surface-modified zirconia particle dispersion liquid 10 was used, respectively, instead of the surface-modified zirconia particle dispersion liquid 1 in the preparation of the composition for forming a light scattering composite, the light scattering composite, and the optical semiconductor light emitting device of Example 1.

With regard to the composition 10 for forming a light scattering composite, the light scattering composite 10, and the optical semiconductor light emitting device 10, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 11]

A composition 11 for forming a light scattering composite, a light scattering composite 11, and an optical semiconductor light emitting device 11 were prepared in the same manner as in Example 1 except that the surface-modified zirconia particle dispersion liquid 11 was used, respectively, instead of the surface-modified zirconia particle dispersion liquid 1 in the preparation of the composition for forming a light scattering composite, the light scattering composite, and the optical semiconductor light emitting device of Example 1.
With regard to the composition 11 for forming a light scattering composite, the light scattering composite 11, and the optical semiconductor light emitting device 11, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 12]

A composition 12 for forming a light scattering composite, a light scattering composite 12, and an optical semiconductor light emitting device 12 were prepared in the same manner as in Example 1 except that the surface-modified zirconia particle dispersion liquid 2 was used, respectively, instead of the surface-modified zirconia particle dispersion liquid 1, the amount thereof was 1 g, and the amount of the phenyl silicone resin was 99.86 g (24.97 g of the liquid A and 74.89 g of the liquid B) in the preparation of the composition for forming a light scattering composite, the light scattering composite, and the optical semiconductor light emitting device of Example 1.
With regard to the composition 12 for forming a light scattering composite, the light scattering composite 12, and the optical semiconductor light emitting device 12, each thus obtained, the same evaluation as in Example 1 was carried out. In addition, a content of the light scattering particles and a content of the yellow phosphor in the light scattering conversion layer were 0.08% by mass and 20% by mass, respectively. Further, the obtained light scattering conversion layer was in a convex shape with respect to the outside air layer. The results are shown in Tables 1 and 2 below.

[Example 13]

A composition 13 for forming a light scattering composite, a light scattering composite 13, and an optical semiconductor light emitting device 13 were prepared in the same manner as in Example 1 except that the surface-modified zirconia particle dispersion liquid 2 was used, respectively, instead of the surface-modified zirconia particle dispersion liquid 1, the amount thereof was 95 g, and the amount of the phenyl silicone resin was 86.7 g (21.68 g of the liquid A and 65.02 g of the liquid B) in the preparation of the composition for forming a light scattering composite, the light scattering composite, and the optical semiconductor light emitting device of Example 1.
With regard to the composition 13 for forming a light scattering composite, the light scattering composite 13, and the optical semiconductor light emitting device 13, each thus obtained, the same evaluation as in Example 1 was carried out. In addition, a content of the light scattering particles and a content of the yellow phosphor in the light scattering conversion layer were 7.6% by mass and 20% by mass, respectively. Further, the obtained light scattering conversion layer was in a convex shape with respect to the outside air layer. The results are shown in Tables 1 and 2 below.

[Example 14]

A composition 14 for forming a light scattering composite, a light scattering composite 14, and an optical semiconductor light emitting device 14 were prepared in the same manner as in Example 1 except that the surface-modified zirconia particle dispersion liquid 2 was used, respectively, instead of the surface-modified zirconia particle dispersion liquid 1, the amount thereof was 140 g, and the amount of the phenyl silicone resin was 80.4 g (20.1 g of the liquid A and 60.3 g of the liquid B) in the preparation of the composition for forming a light scattering composite, the light scattering composite, and the optical semiconductor light emitting device of Example 1.
With regard to the composition 14 for forming a light scattering composite, the light scattering composite 14, and the optical semiconductor light emitting device 14, each thus obtained, the same evaluation as in Example 1 was carried out. In addition, a content of the light scattering particles and a content of the yellow phosphor in the light scattering conversion layer were 11.2% by mass and 20% by mass, respectively. Further, the obtained light scattering conversion layer was in a convex shape with respect to the outside air layer. The results are shown in Tables 1 and 2 below.

[Example 15]

A composition 15 for forming a light scattering composite, a light scattering composite 15, and an optical semiconductor light emitting device 15 were prepared in the same manner as in Example 1 except that the surface-modified zirconia particle dispersion liquid 12 was used, respectively, instead of the surface-modified zirconia particle dispersion liquid 1, and the amount of the phenyl silicone resin was 98.9 g (24.73 g of the liquid A and 74.17 g of the liquid B) in the preparation of the composition for forming a light scattering composite, the light scattering composite, and the optical semiconductor light emitting device of Example 1.

With regard to the composition 15 for forming a light scattering composite 15, the light scattering composite 15, and the optical semiconductor light emitting device 15, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 16]

A composition 16 for forming a light scattering composite, a light scattering composite 16, and an optical semiconductor light emitting device 16 were prepared in the same manner as in Example 1 except that the surface-modified zirconia particle dispersion liquid 13 was used, respectively, instead of the surface-modified zirconia particle dispersion liquid 1, and the amount of the phenyl silicone resin was 98.2 g (24.55 g of the liquid A and 73.65 g of the liquid B) in the preparation of the composition for forming a light scattering composite, the light scattering composite, and the optical semiconductor light emitting device of Example 1.

With regard to the composition 16 for forming a light scattering composite, the light scattering composite 16, and the optical semiconductor light emitting device 16, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 17]

A composition 17 for forming a light scattering composite, a light scattering composite 17, and an optical semiconductor light emitting device 17 were prepared in the same manner as in Example 1 except that the surface-modified zirconia particle dispersion liquid 2 was used, respectively, instead of the surface-modified zirconia particle dispersion liquid 1, and 98.6 g (49.3 g of a liquid A and 49.3 g of a liquid B) of a methyl silicone resin (OE-6336 manufactured by Dow Corning Toray Co., Ltd., a refractive index of 1.41, and a blending ratio of the liquid A/the liquid B = 1/1) was used instead of the phenyl silicone resin in the preparation of the composition for forming a light scattering composite, the light scattering composite, and the optical semiconductor light emitting device of Example 1.

With regard to the composition 17 for forming a light scattering composite, the light scattering composite 17, and the optical semiconductor light emitting device 17, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 18]

A composition 18 for forming a light scattering composite, a light scattering composite 18, and an optical semiconductor light emitting device 18 were prepared in the same manner as in Example 1 except that the surface-modified zirconia particle dispersion liquid 6 was used, respectively, instead of the surface-modified zirconia particle dispersion liquid 1, and 98.6 g (49.3 g of a liquid A and 49.3 g of a liquid B) of a methyl silicone resin (OE-6336 manufactured by Dow Corning Toray Co., Ltd., a refractive index of 1.41, and a blending ratio of the liquid A/the liquid B = 1/1) was used instead of the phenyl silicone resin in the preparation of the composition for forming a light scattering composite, the light scattering composite, and the optical semiconductor light emitting device of Example 1.

With regard to the composition 18 for forming a light scattering composite 18, the light scattering composite 18, and the optical semiconductor light emitting device 18, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Example 19]

A composition 19 for forming a light scattering composite, a light scattering composite 19, and an optical semiconductor light emitting device 19 were prepared in the same manner as in Example 1 except that the amount of the surface-modified zirconia particle dispersion liquid 1 was 50 g, respectively, and the amount of the phenyl silicone resin was 93 g (23.25 g of the liquid A and 69.75 g of the liquid B) in the preparation of the composition for forming a light scattering composite, the light scattering composite, and the optical semiconductor light emitting device of Example 1.

With regard to the composition 19 for forming a light scattering composite, the light scattering composite 19, and the optical semiconductor light emitting device 19, each thus obtained, the same evaluation as in Example 1 was carried out. In addition, a content of the light scattering particles and a content of the yellow phosphor in the light scattering conversion layer were 4% by mass and 20% by mass, respectively. Further, the obtained light scattering conversion layer was in a convex shape with respect to the outside air layer. The results are shown in Tables 1 and 2 below.

[Example 20]

A composition 20 for forming a light scattering composite, a light scattering composite 20, and an optical semiconductor light emitting device 20 were prepared in the same manner as in Example 1 except that the surface-modified silica particle dispersion liquid 8 was used, respectively, instead of the surface-modified zirconia particle dispersion liquid 1, the amount thereof was 5 g, and 99.3 g (49.65 g of a liquid A and 49.65 g of a liquid B) of a methyl silicone resin (OE-6336 manufactured by Dow Corning Toray Co., Ltd., a refractive index of 1.41, and a blending ratio of the liquid A/the liquid B = 1/1) was used instead of the phenyl silicone resin in the preparation of the composition for forming a light scattering composite, the light scattering composite, and the optical semiconductor light emitting device of Example 1.

With regard to the composition 20 for forming a light scattering composite, the light scattering composite 20, and the optical semiconductor light emitting device 20, each thus obtained, the same evaluation as in Example 1 was carried out. In addition, a content of the light scattering particles and a content of the yellow phosphor in the light scattering conversion layer were 0.4% by mass and 20% by mass, respectively. Further, the obtained light scattering conversion layer was in a convex shape with respect to the outside air layer. The results are shown in Tables 1 and 2 below.

[Example 21]

A composition 21 for forming a light scattering composite and a light scattering composite 21 were prepared in the same manner as in Example 2. Accordingly, the composition 21 for forming a light scattering composite and the light scattering composite 21 were the same as the composition 2 for forming a light scattering composite 2 and the light scattering composite 2, respectively.

(Preparation of Optical Semiconductor Light Emitting Device 21)

5 g of a yellow phosphor (GLD(Y)-550A manufactured by GeneLite Inc.) was added to 20 g of the composition 21 for forming a light scattering composite, and then the mixture was mixed and defoamed by a rotation-revolution type mixer to obtain a phosphor-containing composition 21 for forming a light scattering composite. Subsequently, the phosphor-containing composition 21 for forming a light scattering composite was added dropwise onto a light emitting element of a package including an unsealed blue optical semiconductor light emitting element, and then, the mixture was heated at 150°C for 2 hours to cure the composition 21 for forming a light scattering composite. As a result, an optical semiconductor light emitting device 21 of Example 21, in which a light scattering conversion layer including the light scattering particles and the phosphor was formed on the optical semiconductor light emitting element, was prepared.

In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer.

With regard to the obtained optical semiconductor light emitting device 21, the same evaluation as in Example 1 was carried out. The results are shown in Table 2 below.

[Example 22]

A composition 22 for forming a light scattering composite and a light scattering composite 22 were prepared in the same manner as in Example 2. Accordingly, the composition 22 for forming a light scattering composite and the light scattering composite 22 were the same as the composition 2 for forming a light scattering composite 2 and the light scattering composite 2, respectively.

(Preparation of Optical Semiconductor Light Emitting Device 22)

10 g of a yellow phosphor (GLD(Y)-550A manufactured by GeneLite Inc.) was added to 15 g (3.75 g of a liquid A and 11.25 g of a liquid B) of a phenyl silicone resin (OE-6635 manufactured by Dow Corning Toray Co., Ltd., a refractive index of 1.54, and a blending ratio of the liquid A/the liquid B = 1/3), and then the mixture was mixed and defoamed by a rotation-revolution type mixer to obtain a phosphor-containing resin composition 22.

Subsequently, the phosphor-containing resin composition 22 was added dropwise onto a light emitting element of a package including an unsealed blue optical semiconductor light emitting element. Then, the mixture was heated at 150°C for 30 minutes to cure the phosphor-containing resin composition 22. Then, the composition 22 for forming a light scattering composite in the same amount as that of the phosphor-containing resin composition 22 was added dropwise onto the cured phosphor-containing resin composition 22. Then, the mixture was heated at 150°C for 90 minutes to cure the composition 22 for forming a light scattering composite while completing curing the phosphor-containing resin composition 22. As a result, an optical semiconductor light emitting device 22 of Example 22, in which a phosphor-containing light conversion layer was formed on the optical semiconductor light emitting element, and a light scattering layer containing light scattering particles was formed thereon, was prepared.

In addition, a content of the yellow phosphor in the light conversion layer and a content of the light scattering particles in the light scattering layer were 40% by mass and 1% by mass, respectively. Further, the obtained light scattering layer was in a convex shape with respect to the outside air layer.

With regard to the obtained optical semiconductor light emitting device 22, the same evaluation as in Example 1 was carried out. The results are shown in Table 2 below.

[Comparative Example 1]

(Evaluation of Matrix Resin)

10 g (2.5 g of a liquid A and 7.5 g of a liquid B) of a phenyl silicone resin (OE-6635 manufactured by Dow Corning Toray Co., Ltd., a refractive index of 1.54, and a blending ratio of the liquid A/the liquid B = 1/3) was mixed and defoamed by a rotation-revolution type mixer, and then the obtained matrix resin composition was measured in the same manner as for the light scattering composition in each of Examples, and evaluated. Further, the obtained matrix resin composition was poured into a mold in a concave shape having a depth of 1 mm, and cured by heating at 150°C for 2 hours to prepare a matrix resin cured body having a thickness of 1 mm. The matrix resin cured body was measured in the same manner as for the light scattering composite in Examples, and evaluated. The results are shown in Table 1 below.

(Preparation of Optical Semiconductor Light Emitting Device)

10 g of a yellow phosphor (GLD(Y)-550A manufactured by GeneLite Inc.) was added to 15 g (3.75 g of a liquid A and 11.25 g of a liquid B) of a phenyl silicone resin (OE-6635 manufactured by Dow Corning Toray Co., Ltd., a refractive index of 1.54, and a blending ratio of the liquid A/the liquid B = 1/3), and then the mixture was mixed and defoamed by a rotation-revolution type mixer to obtain a phosphor-containing phenyl silicone resin composition. Subsequently, the phosphor-containing phenyl silicone resin composition was added dropwise onto a light emitting element of a package including an unsealed blue optical semiconductor light emitting element. The non-phosphor-containing phenyl silicone resin composition in the same amount as that of the phosphor-containing phenyl silicone resin composition was added dropwise thereto, and the mixture was cured by heating at 150°C for 2 hours. As a result, an optical semiconductor light emitting device 101 of Comparative Example 1, in which a phosphor-containing light conversion layer was formed on the optical semiconductor light emitting element, was prepared.

In addition, a content of the yellow phosphor in the light conversion layer was 20% by mass. Further, the obtained light conversion layer was in a convex shape with respect to the outside air layer.

The light emission spectrum and the luminance of the obtained optical semiconductor light emitting device 101 were measured as described above, and taken as standard values. The results are shown in Table 2 below.

[Comparative Example 2]

(Evaluation of Matrix Resin)

The characteristics of the matrix resin composition and the matrix resin cured body were measured and evaluated in the same manner as in Comparative Example 1 except that 10 g (5 g of a liquid A and 5 g of a liquid B) of a dimethyl silicone resin (OE-6336 manufactured by Dow Corning Toray Co., Ltd., a refractive index of 1.41, and a blending ratio of the liquid A/the liquid B = 1/1) was used instead of the phenyl silicone resin in the evaluation of the matrix resin of Comparative Example 1. The results are shown the following Table 1.

(Preparation of Optical Semiconductor Light Emitting Device)

An optical semiconductor light emitting device 102 was prepared in the same manner as in Comparative Example 1 except that 15 g (7.5 g of a liquid A and 7.5 g of a liquid B) of a dimethyl silicone resin (OE-6336 manufactured by Dow Corning Toray Co., Ltd., a refractive index of 1.41, and a blending ratio of the liquid A/the liquid B = 1/1) was used instead of the phenyl silicone resin in the preparation of the optical semiconductor light emitting device of Comparative Example 1.

In addition, a content of the yellow phosphor in the light conversion layer was 20% by mass. Further, the obtained light conversion layer was in a convex shape with respect to the outside air layer.

The light emission spectrum and the luminance of the obtained optical semiconductor light emitting device 102 were measured as described above, and taken as standard values. The results are shown in Table 2 below.

[Comparative Example 3]

A composition 103 for forming a light scattering composite, a light scattering composite 103, and an optical semiconductor light emitting device 103 were prepared in the same manner as in Example 1 except that the surface-modified zirconia particle dispersion liquid 14 was used, respectively, instead of the surface-modified zirconia particle dispersion liquid 1 in the preparation of the composition for forming a light scattering composite, the light scattering composite, and the optical semiconductor light emitting device of Example 1.

With regard to the composition 103 for forming a light scattering composite, the light scattering composite 103, and the optical semiconductor light emitting device 103, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Comparative Example 4]

A composition 104 for forming a light scattering composite, a light scattering composite 104, and an optical semiconductor light emitting device 104 were prepared in the same manner as in Example 1 except that the surface-modified zirconia particle dispersion liquid 15 was used, respectively, instead of the surface-modified zirconia particle dispersion liquid 1, and the amount of the phenyl silicone resin was 98.8 g (24.8 g of the liquid A and 74.1 g of the liquid B) in the preparation of the composition for forming a light scattering composite, the light scattering composite, and the optical semiconductor light emitting device of Example 1. Further, the surface-modified zirconia particle dispersion liquid 15 in the state where it included settling particles was used.

With regard to the composition 104 for forming a light scattering composite, the light scattering composite 104, and the optical semiconductor light emitting device 104, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Comparative Example 5]

A composition 105 for forming a light scattering composite, a light scattering composite 105, and an optical semiconductor light emitting device 105 were prepared in the same manner as in Example 1 except that the surface-modified silica particle dispersion liquid 16 was used, respectively, instead of the surface-modified zirconia particle dispersion liquid 1, and the amount of the phenyl silicone resin was 98.65 g (24.66 g of the liquid A and 73.99 g of the liquid B) in the preparation of the composition for forming a light scattering composite, the light scattering composite, and the optical semiconductor light emitting device of Example 1.

With regard to the composition 105 for forming a light scattering composite, the light scattering composite 105, and the optical semiconductor light emitting device 105, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Comparative Example 6]

A composition 106 for forming a light scattering composite, a light scattering composite 106, and an optical semiconductor light emitting device 106 were prepared in the same manner as in Example 1 except that the surface-modified zirconia particle dispersion liquid 17 was used, respectively, instead of the surface-modified zirconia particle dispersion liquid 1 in the preparation of the composition for forming a light scattering composite, the light scattering composite, and the optical semiconductor light emitting device of Example 1. Further, the composition 106 for forming a light scattering composite was transparent, while the cured light scattering composite 106 was white turbid.

With regard to the composition 106 for forming a light scattering composite, the light scattering composite 106, and the optical semiconductor light emitting device 106, each thus obtained, the same evaluation as in Example 1 was carried out. In addition, a content of the light scattering particles and a content of the yellow phosphor in the light scattering conversion layer were 0.8% by mass and 20% by mass, respectively. Further, the obtained light scattering conversion layer was in a convex shape with respect to the outside air layer. The results are shown in Tables 1 and 2 below.

[Comparative Example 7]

A composition 107 for forming a light scattering composite, a light scattering composite 107, and an optical semiconductor light emitting device 107 were prepared in the same manner as in Example 1 except that the surface-modified zirconia particle dispersion liquid 2 was used, respectively, instead of the surface-modified zirconia particle dispersion liquid 1, the amount thereof was 200 g, and the amount of the phenyl silicone resin was 72 g (18 g of the liquid A and 54 g of the liquid B) in the preparation of the composition for forming a light scattering composite, the light scattering composite, and the optical semiconductor light emitting device of Example 1. Further, the composition 107 for forming a light scattering composite had high viscosity. In addition, the viscosity of the phosphor-containing light scattering composition 107 formed by adding yellow phosphor particles to the composition 107 for forming a light scattering composite was very high, and defoaming could not be completely carried out in the phosphor-containing light scattering composition 107. As a result, the light scattering conversion layer was present in the state where air bubbles were incorporated therein.

With regard to the composition 107 for forming a light scattering composite, the light scattering composite 107, and the optical semiconductor light emitting device 107, each thus obtained, the same evaluation as in Example 1 was carried out. In addition, a content of the light scattering particles and a content of the yellow phosphor in the light scattering conversion layer were 16% by mass and 20% by mass, respectively. Further, the obtained light scattering conversion layer was in a convex shape with respect to the outside air layer. The results are shown in Tables 1 and 2 below.

[Comparative Example 8]

A composition 108 for forming a light scattering composite, a light scattering composite 108, and an optical semiconductor light emitting device 108 were prepared in the same manner as in Example 1 except that the surface-modified silica particle dispersion liquid 9 was used, respectively, instead of the surface-modified zirconia particle dispersion liquid 1, the amount thereof was 200 g, and 72 g (36 g of a liquid A and 36 g of a liquid B) of a methyl silicone resin (OE-6336 manufactured by Dow Corning Toray Co., Ltd., a refractive index of 1.41, and a blending ratio of the liquid A/the liquid B = 1/1) was used instead of the phenyl silicone resin in the preparation of the composition for forming a light scattering composite, the light scattering composite, and the optical semiconductor light emitting device of Example 1. In addition, the viscosity of the phosphor-containing light scattering composition 108 formed by adding yellow phosphor particles to the composition 108 for forming a light scattering composite was very high, and defoaming could not be completely carried out in the phosphor-containing light scattering composition 108. As a result, the light scattering conversion layer was present in the state where air bubbles were incorporated therein.

With regard to the composition 108 for forming a light scattering composite, the light scattering composite 108, and the optical semiconductor light emitting device 108, each thus obtained, the same evaluation as in Example 1 was carried out. In addition, a content of the light scattering particles and a content of the yellow phosphor in the light scattering conversion layer were 16% by mass and 20% by mass, respectively. Further, the obtained light scattering conversion layer was in a convex shape with respect to the outside air layer. The results are shown in Tables 1 and 2 below.

[Table 1]

| | Surface-modified particle | | | | Dispersion liquid | | Composition for forming a light scattering composite | | | | | | |
|---|---|---|---|---|---|---|---|---|---|---|---|---|---|
| | Particles | | Surface modification material | | | | | | | | Integrated transmittance (%) | | |
| | Type of particles | Average primary particle diameter (nm) | Functional group | Modification amount (w%) | Dispersion liquid No. | Transparency | Average dispersed particle diameter (nm) | Matrix resin | Content of particles (w%) | Transparency | 460 nm | 550 nm | Evaluation |
| Example 1 | $ZrO_2$-1 | 5.5 | Alkenyl | 40 | Zirconia-1 | Transparent | 8.3 | OE-6635 | 1 | Transparent | 91 | 98 | Good |
| Example 2 | $ZrO_2$-1 | 5.5 | Alkenyl | 40 | Zirconia-2 | Transparent | 15.6 | OE-6635 | 1 | Transparent | 85 | 91 | Good |
| Example 3 | $ZrO_2$-1 | 5.5 | Alkenyl | 25 | Zirconia-3 | Slightly white turbid | 78.5 | OE-6635 | 1 | Slightly white turbid | 61 | 84 | Good |
| Example 4 | $ZrO_2$-2 | 2.1 | Alkenyl | 40 | Zirconia-4 | Transparent | 10.6 | OE-6635 | 1 | Transparent | 92 | 98 | Good |
| Example 5 | $ZrO_2$-2 | 2.1 | Alkenyl | 30 | Zirconia-5 | Approximately transparent | 46.2 | OE-6635 | 1 | Approximately transparent | 72 | 88 | Good |
| Example 6 | $ZrO_2$-3 | 42.1 | Alkenyl | 40 | Zirconia-6 | Slightly white turbid | 85.3 | OE-6635 | 1 | Slightly white turbid | 62 | 75 | Good |
| Example 7 | $ZrO_2$-3 | 42.1 | Alkenyl | 35 | Zirconia-7 | Turbid | 142 | OE-6635 | 1 | Slightly white turbid | 45 | 77 | Good |
| Example 8 | $SiO_2$ | 9.5 | Alkenyl | 40 | Silica-8 | Transparent | 13.2 | OE-6635 | 1 | Transparent | 85 | 94 | Good |
| Example 9 | $SiO_2$ | 9.5 | Alkenyl | 40 | Silica-9 | Transparent | 23.7 | OE-6635 | 1 | Transparent | 78 | 90 | Good |
| Example 10 | $ZrO_2$-1 | 5.5 | H-Si | 40 | Zirconia-10 | Transparent | 17.2 | OE-6635 | 1 | Transparent | 88 | 94 | Good |
| Example 11 | $ZrO_2$-1 | 5.5 | Alkoxy | 40 | Zirconia-11 | Transparent | 16.9 | OE-6635 | 1 | Transparent | 90 | 96 | Good |

(continued)

| | Surface-modified particle | | | | Dispersion liquid | | Composition for forming a light scattering composite | | | | | | |
|---|---|---|---|---|---|---|---|---|---|---|---|---|---|
| | Particles | | Surface modification material | | | | Average dispersed particle diameter (nm) | Matrix resin | Content of particles (w%) | | Integrated transmittance (%) | | |
| | Type of particles | Average primary particle diameter (nm) | Functional group | Modification amount (w%) | Dispersion liquid No. | Transparency | | | | Transparency | 460 nm | 550 nm | Evaluation |
| Example 12 | $ZrO_2$-1 | 5.5 | Alkenyl | 40 | Zirconia-2 | Transparent | 15.2 | OE-6635 | 0.1 | Transparent | 81 | 92 | Good |
| Example 13 | $ZrO_2$-1 | 5.5 | Alkenyl | 40 | Zirconia-2 | Transparent | 22.7 | OE-6635 | 9.5 | Transparent | 79 | 88 | Good |
| Example 14 | $ZrO_2$-1 | 5.5 | Alkenyl | 40 | Zirconia-2 | Transparent | 24.1 | OE-6635 | 14 | Transparent | 55 | 71 | Good |
| Example 15 | $ZrO_2$-2 | 2.1 | Alkenyl | 10 | Zirconia-12 | Transparent | 3.8 | OE-6635 | 1 | Transparent | 54 | 77 | Good |
| Example 16 | $ZrO_2$-1 | 5.5 | Alkenyl | 80 | Zirconia-13 | Transparent | 16.5 | OE-6635 | 1 | Transparent | 89 | 96 | Good |
| Example 17 | $ZrO_2$-1 | 5.5 | Alkenyl | 40 | Zirconia-2 | Transparent | 15.4 | OE-6336 | 1 | Transparent | 87 | 93 | Good |
| Example 18 | $ZrO_2$-3 | 42.1 | Alkenyl | 40 | Zirconia-6 | Slightly white turbid | 89.2 | OE-6336 | 1 | Slightly white turbid | 48 | 77 | Good |
| Example 19 | $ZrO_2$-1 | 5.5 | Alkenyl | 40 | Zirconia-1 | Transparent | 8.2 | OE-6635 | 5 | Transparent | 63 | 84 | Good |
| Example 20 | $SiO_2$ | 9.5 | Alkenyl | 40 | Silica-8 | Transparent | 13.5 | OE-6336 | 0.5 | Transparent | 91 | 97 | Good |
| Example 21 | $ZrO_2$-1 | 5.5 | Alkenyl | 40 | Zirconia-2 | Transparent | 15.6 | OE-6635 | 1 | Transparent | 85 | 91 | Good |
| Example 22 | $ZrO_2$-1 | 55 | Alkenyl | 40 | Zirconia-2 | Transparent | 15.6 | OE-6635 | 1 | Transparent | 85 | 91 | Good |

34

(continued)

| | Surface-modified particle | | | | Dispersion liquid | | Average dispersed particle diameter (nm) | Composition for forming a light scattering composite | | | | | |
| | Particles | | Surface modification material | | | | | | | | Integrated transmittance (%) | | |
| | Type of particles | Average primary particle diameter (nm) | Functional group | Modification amount (w%) | Dispersion liquid No. | Transparency | | Matrix resin | Content of particles (w%) | Transparency | 460 nm | 550 nm | Evaluation |
|---|---|---|---|---|---|---|---|---|---|---|---|---|---|
| Comparative Example 1 | (None) | - | - | - | - | - | - | OE-6635 | - | (Transparent) | 96 | 98 | Poor |
| Comparative Example 2 | (None) | - | - | - | - | - | - | OE-6336 | - | (Transparent) | 95 | 98 | Poor |
| Comparative Example 3 | ZrO$_2$-2 | 2.1 | Alkenyl | 40 | Zirconia-14 | Transparent | 2.8 | OE-6635 | 1 | Transparent | 95 | 97 | Poor |
| Comparative Example 4 | ZrO$_2$-3 | 42.1 | Alkenyl | 20 | Zirconia-15 | Turbid·settling | 835 | OE-6635 | 1 | Turbid·settling | 25 | 51 | Poor |
| Comparative Example 5 | SiO$_2$ | 9.5 | Alkenyl | 35 | Silica-16 | Turbid | 176 | OE-6635 | 1 | Turbid | 64 | 81 | Good |
| Comparative Example 6 | ZrO$_2$-1 | 5.5 | Alkyl | 40 | Zirconia-17 | Transparent | 15.1 | OE-6635 | 1 | Transparent | 45 | 82 | Good |
| Comparative Example 7 | ZrO$_2$-1 | 5.5 | Alkenyl | 40 | Zirconia-2 | Transparent | 37.4 | OE-6635 | 20 | Approximately transparent | 44 | 68 | Poor |
| Comparative Example 8 | SiO$_2$ | 9.5 | Alkenyl | 40 | Silica-9 | Transparent | 12.3 | OE-6336 | 20 | Transparent | 82 | 90 | Good |

[Table 2]

| | Light scattering composite | | | | | | | Optical semiconductor light emitting device characteristics | |
|---|---|---|---|---|---|---|---|---|---|
| Average particle diameter of the light scattering particles (nm) | 460 nm | | 550 nm | | Dispersion state of light scattering particles | Integrated transmittance ratio at 550 nm: Tb/Ta | | Evaluation of light emission spectrum | Evaluation of luminance |
| | Integrated transmittance (%) | Linear transmittance (%) | Integrated transmittance (%) | Linear transmittance (%) | | | | | |
| Example 1 — 15.2 | 84 | 35 | 88 | 55 | Uniform | 0.90 | | Good | Good |
| Example 2 — 30.1 | 80 | 29 | 82 | 51 | Uniform | 0.90 | | Good | Good |
| Example 3 — 113.2 | 55 | 20 | 71 | 42 | Uniform | 0.85 | | Good | Good |
| Example 4 — 25.8 | 85 | 59 | 88 | 75 | Uniform | 0.90 | | Good | Good |
| Example 5 — 75.3 | 69 | 41 | 79 | 55 | Uniform | 0.90 | | Good | Good |
| Example 6 — 167.4 | 51 | 25 | 62 | 41 | Uniform | 0.83 | | Good | Good |
| Example 7 — 250.6 | 39 | 12 | 55 | 34 | Uniform | 0.71 | | Good | Good |
| Example 8 — 37.8 | 81 | 52 | 85 | 70 | Uniform | 0.90 | | Good | Possible |
| Example 9 — 48.5 | 75 | 49 | 78 | 61 | Uniform | 0.87 | | Good | Possible |
| Example 10 — 40.2 | 79 | 31 | 85 | 51 | Uniform | 0.90 | | Good | Good |
| Example 11 — 38.5 | 82 | 34 | 86 | 59 | Uniform | 0.90 | | Good | Good |
| Example 12 — 29.1 | 77 | 49 | 83 | 64 | Uniform | 0.90 | | Good | Good |
| Example 13 — 50.3 | 65 | 32 | 78 | 46 | Uniform | 0.89 | | Good | Good |
| Example 14 — 87.3 | 36 | 12 | 45 | 24 | Uniform | 0.63 | | Good | Good |
| Example 15 — 10.9 | 46 | 17 | 65 | 37 | Uniform | 0.84 | | Good | Good |
| Example 16 — 37.8 | 81 | 42 | 86 | 55 | Uniform | 0.90 | | Good | Good |
| Example 17 — 42.1 | 72 | 31 | 84 | 54 | Uniform | 0.90 | | Good | Good |
| Example 18 — 200.5 | 37 | 14 | 50 | 27 | Uniform | 0.65 | | Good | Good |
| Example 19 — 20.8 | 46 | 4 | 72 | 20 | Uniform | 0.86 | | Good | Good |
| Example 20 — 27.6 | 83 | 35 | 87 | 57 | Uniform | 0.90 | | Good | Good |

| | Light scattering composite | | | | | | | Optical semiconductor light emitting device characteristics | |
|---|---|---|---|---|---|---|---|---|---|
| | Average particle diameter of the light scattering particles (nm) | Integrated transmittance (%) | Linear transmittance (%) | Integrated transmittance (%) | Linear transmittance (%) | Dispersion state of light scattering particles | Integrated transmittance ratio at 550 nm: Tb/Ta | Evaluation of light emission spectrum | Evaluation of luminance |
| | | 460 nm | | 550 nm | | | | | |
| Example 21 | 36.2 | 80 | 29 | 82 | 51 | Uniform | 0.90 | Good | Good |
| Example 22 | 36.2 | 80 | 29 | 82 | 51 | Uniform | 0.90 | Good | Good |
| Comparative Example 1 | - | 91 | 80 | 94 | 90 | - | 0.96 | Peak area ratio:0.3 | 60,500 [cd/cm$^2$] |
| Comparative Example 2 | - | 92 | 81 | 97 | 89 | - | 0.99 | Peak area ratio:0.3 | 60,500 [cd/cm$^2$] |
| Comparative Example 3 | 9.8 | 89 | 71 | 95 | 84 | Uniform | 0.98 | Poor | Possible |
| Comparative Example 4 | 1,150.2 | 12 | 2 | 21 | 18 | Non-uniform (settling) | 0.41 | Good | Poor |
| Comparative Example 5 | 356.5 | 61 | 38 | 73 | 46 | Slightly non-uniforn | 0.90 | Poor | Poor |
| Comparative Example 6 | 1,780 | 25 | 11 | 39 | 26 | Non-uniform | 0.48 | Good | Poor |
| Comparative Example 7 | 78.9 | 35 | 17 | 51 | 35 | Uniform | 0.75 | Poor | Poor |
| Comparative Example 8 | 24.5 | 51 | 30 | 75 | 44 | Uniform | 0.83 | Poor | Poor |

As described above, all of the compositions 1 to 22 for forming a light scattering composite used in the respective Examples (Examples 1 to 22) had good transmittance characteristics. That is, for the integrated transmittances in the samples having a thickness of 1.0 mm, the transmittance at a wavelength of 460 nm was 40% or more and 95% or less, and the transmittance at a wavelength of 550 nm was 70% or more. In addition, good results of being transparent or nearly transparent upon observation with the naked eyes were obtained.

Furthermore, all of the light scattering composites 1 to 22 of the respective Examples had characteristics that the values themselves of the integrated transmittance were high, the integrated transmittance was higher than the linear transmittance, and the integrated transmittance at a wavelength of 550 nm was higher than the integrated transmittance at a wavelength of 460 nm. Accordingly, by applying these light scattering composites 1 to 22 to a light scattering layer or a light scattering conversion layer in a white optical semiconductor light emitting device in which a blue optical semiconductor light emitting element and a phosphor are combined with each other, in particular, to a white optical semiconductor light emitting device in a blue optical semiconductor light emitting element and a yellow phosphor are combined with each other, effects that blue light irradiation is suppressed and white light luminance is enhanced can be obtained. That is, the light scattering composites 1 to 22 are materials which can be appropriately used for a light scattering layer or a light scattering conversion layer in a white optical semiconductor light emitting device in which a blue optical semiconductor light emitting element and a phosphor are combined with each other.

Moreover, the average particle diameter of the light scattering particles (inorganic oxide particles) in the light scattering composites 1 to 22 was within a range of 10 nm to 1,000 nm, and was thus appropriate as an average particle diameter for obtaining the optical characteristics.

Furthermore, when the average dispersed particle diameter of the surface-modified inorganic oxide particles in the compositions 1 to 22 for forming a light scattering composite used in the respective Examples was compared with the average particle diameter of the light scattering particles (inorganic oxide particles) in the light scattering composites 1 to 22 which are cured products of the compositions, the average particle diameter of the light scattering particles of all of the light scattering composites 1 to 22 was increased. Further, a ratio of an integrated transmittance $T_a$ at a wavelength of 550 nm of the compositions 1 to 22 for forming a light scattering composite to an integrated transmittance $T_b$ at a wavelength of 550 nm of the light scattering composites 1 to 22, a $T_b/T_a$ value, was all 0.9 or less. From this viewpoint, it was confirmed that when the composition for forming a light scattering composite is cured to form a light scattering composite, at least some of dispersed particles (surface-modified inorganic oxide particles) dispersed in the composition for forming a light scattering composite were associated to form associated particles in the matrix resin of the light scattering composite, and as a result, the light scattering ability in the light scattering composite is enhanced.

Furthermore, the light scattering particles in the light scattering composites 1 to 22 were uniformly dispersed. This can be said to prove that the dispersed particles uniformly dispersed in the compositions 1 to 22 for forming a light scattering composite form associated particles when the compositions for forming a light scattering composite are cured to form light scattering composites.

Moreover, in all of the optical semiconductor light emitting devices 1 to 22 in the respective Examples, the light emission spectrum peak area ratios were excellent, as compared with Comparative Example 1 or 2, which were standard values. That is, the ratio of a light emission spectrum peak area a at a wavelength of 400 nm to 480 nm to a light emission spectrum peak area b at a wavelength of 480 nm to a wavelength of 800 nm, a ratio a/b value, was less than 0.3, and the blue light components emitted together with white light were reduced.

In addition, all of the optical semiconductor light emitting devices 1 to 22 had high luminance and the luminance was 60,500 cd/cm$^2$ or more.

Accordingly, it was confirmed that all of the optical semiconductor light emitting devices 1 to 22 in the respective Examples had good characteristics.

On the other hand, in Comparative Example 3, the characteristics of the composition 103 for forming a light scattering composite were not substantially different from those of the single substance of the matrix resin, and the characteristics of the light scattering composite 103 were values close to those of the single substance of the matrix resin. This is thought to be caused by a fact that when the composition 103 for forming a light scattering composite was cured to form the light scattering composite 103, association of the zirconia particles did not almost occur, the average particle diameter of the light scattering particles in light scattering composite 103 was thus extremely small, and therefore, the light scattering ability was almost not expressed. As a result, the characteristics of the optical semiconductor light emitting device 103 were also the same as those of the optical semiconductor light emitting device 101, which were standard values.

In Comparative Example 4, as the settling of the zirconia particles in the surface-modified zirconia particle dispersion liquid 15 and the composition 104 for forming a light scattering composite was shown, the dispersed particle diameters of the light scattering particles are excessive, and as a result, light scattering ability became extremely high. Therefore, the characteristics of the composition 104 for forming a light scattering composite and the light scattering composite 104 were reduced, and there was also a remarkable reduction, in particular, in luminance in the optical semiconductor light emitting device 104.

In Comparative Example 5, the dispersed particle diameters of the silica particles (light scattering particles) in the composition 105 for forming a light scattering composite were excessively large. However, in a view that the difference between the refractive index of the silica particles and that of the matrix resin was small, the light scattering ability was smaller than that of the zirconia particles, and as a result, a significant problem in the characteristics of the composition 105 for forming a light scattering composite and the light scattering composite 105 did not occur. However, in the optical semiconductor light emitting device 105, good characteristics in terms of the light emission spectrum peak area ratio and the luminance were not obtained.

In Comparative Example 6, the characteristics of the composition 106 for forming a light scattering composite were good, but the cured light scattering composite 106 was white turbid, the dispersion of the light scattering particles was thus non-uniform, and the characteristics thereof were also reduced. This is thought to be caused by a fact that stearic acid having no functional group was used as a surface modifier of the zirconia particles (light scattering particles) after surface modification. That is, since the zirconia particles were subjected to sufficient surface modification in the surface-modified zirconia particle dispersion liquid 17 and the composition 106 for forming a light scattering composite, the surface-modified zirconia particles maintained a good dispersion state, whereas since the surface modifier has no functional group capable of being bonded with the matrix resin, it is thought that if the matrix resin was cured, phase separation between the surface-modified zirconia particles and the matrix resin occurred, leading to formation of coarse particles, and thus, the light scattering ability became excessive.

Thus, since the light scattering ability in the light scattering composite 106 was excessive, there was a remarkable reduction, in particular, in luminance in the optical semiconductor light emitting device 106.

In Comparative Example 7, the composition 107 for forming a light scattering composite and the light scattering composite 107 had a large amount of the zirconia particles (light scattering particles). Therefore, the light scattering ability became excessively large, and as a result, it is thought that the characteristics of the composition 107 for forming a light scattering composite and the light scattering composite 107 were reduced. In addition, the composition 107 for forming a light scattering composite has a high content of the zirconia particles (light scattering particles), and thus had a high viscosity and a difficulty in handling. In addition, the phosphor-containing light scattering composition 107 additionally had yellow phosphor particles, in addition to the zirconia particles, and therefore, the viscosity was much increased, defoaming could not be carried out, and there was also a difficulty in handling. Thus, in the optical semiconductor light emitting device 107, good characteristics in terms of the light emission spectrum peak area ratio and the luminance were not obtained.

In Comparative Example 8, the amount of the silica particles (light scattering particles) used in the same manner as in Comparative Example 7 was large. As a result, it is thought that in the same manner as in Comparative Example 7, an excessively large light scattering ability, or insufficient defoaming or a difficulty in handling due to a high viscosity occurred, and thus, good characteristics were not obtained.

Reference Signs List

10    Optical semiconductor light emitting element
11    Sealing resin layer
12    Light scattering composite
13    Phosphor particles
14    Light scattering conversion layer
15    Matrix material
16    Light conversion layer
17    Light scattering layer
18    Outside air phase interface

**Claims**

1.    A composition for forming a light scattering composite (12), comprising:

surface-modified inorganic oxide particles surface-modified by a surface modification material having one or more functional groups selected from a group consisting of an alkenyl group, an H-Si group, and an alkoxy group; and
an uncured matrix resin composition,
wherein an average dispersed particle diameter of the surface-modified inorganic oxide particles is 3 nm or more and 150 nm or less, and **characterized in that** a content of the surface-modified inorganic oxide particles is 0.01% by mass or more and 5% by mass or less with respect to a total amount of the composition for forming a light scattering composite.

2. The composition for forming a light scattering composite (12) according to claim 1, wherein a transmittance Ta at a wavelength of 550 nm measured with an integrating sphere with respect to the composition before curing and a transmittance Tb at a wavelength of 550 nm measured with an integrating sphere with respect to a cured product after curing meet a relationship of Expression (1),

$$Tb/Ta \leq 0.90 \cdots \text{Expression (1)}.$$

3. The composition for forming a light scattering composite (12) according to claim 1 or 2, further comprising phosphor particles (13).

4. A light scattering composite (12) formed by curing the composition for forming a light scattering composite according to any one of claims 1 to 3,
wherein at least some of the surface-modified inorganic oxide particles form associated particles, and an average particle diameter of all particles formed by the surface-modified inorganic oxide particles is 10 nm or more and 1,000 nm or less.

5. The light scattering composite (12) according to claim 4, wherein all particles formed by the surface-modified inorganic oxide particles are uniformly dispersed in the light scattering composite.

6. A method for producing a light scattering composite (12), comprising:

a step of curing a composition for forming a light scattering composite, comprising surface-modified inorganic oxide particles surface-modified by a surface modification material having one or more functional groups selected from a group consisting of an alkenyl group, an H-Si group, and an alkoxy group, and an uncured matrix resin composition, in which an average dispersed particle diameter of the surface-modified inorganic oxide particles is 3 nm or more and 150 nm or less, and **characterized in that** a content of the surface-modified inorganic oxide particles is 0.01% by mass or more and 5% by mass or less with respect to a total amount of the composition for forming a light scattering composite,
wherein during curing, at least some of dispersed particles in the composition for forming a light scattering composite are associated to form associated particles in a matrix resin.

7. The method for producing a light scattering composite (12) according to claim 6, wherein curing is carried out so that an average particle diameter of all particles formed by the surface-modified inorganic oxide particles in the light scattering composite is larger than the average dispersed particle diameter in the composition for forming a light scattering composite, and is 10 nm or more and 1,000 nm or less.

8. An optical semiconductor light emitting device, comprising an optical semiconductor light emitting element (10), phosphor particles (13), and a light scattering composite (12) according to claim 4.

**Patentansprüche**

1. Zusammensetzung zum Bilden eines Lichtstreuungsverbunds (12), umfassend:

oberflächenmodifizierte anorganische Oxidteilchen, die durch ein Oberflächenmodifikationsmaterial mit einer oder mehreren funktionellen Gruppen, ausgewählt aus einer Gruppe bestehend aus einer Alkenylgruppe, einer H-Si-Gruppe und einer Alkoxygruppe, oberflächenmodifiziert sind; und
eine ungehärtete Matrix-Harzzusammensetzung,
wobei ein durchschnittlicher Durchmesser verteilter Teilchen der oberflächenmodifizierten anorganischen Oxidteilchen 3 nm oder mehr und 150 nm oder weniger beträgt und **dadurch gekennzeichnet ist, dass** ein Gehalt der oberflächenmodifizierten anorganischen Oxidteilchen 0,01 Massen-% oder mehr und 5 Massen-% oder weniger in Bezug auf eine Gesamtmenge der Zusammensetzung zum Bilden eines Lichtstreuungsverbunds beträgt.

2. Zusammensetzung zum Bilden eines Lichtstreuungsverbunds (12) gemäß Anspruch 1, wobei ein Transmissionsgrad Ta bei einer Wellenlänge von 550 nm, gemessen mit einer Integrationskugel in Bezug auf die Zusammensetzung vor dem Aushärten, und ein Transmissionsgrad Tb bei einer Wellenlänge von 550 nm gemessen mit einer Integrationskugel in Bezug auf ein ausgehärtetes Produkt nach dem Aushärten, eine Beziehung gemäß Ausdruck (1) erfüllen,

$$\mathrm{Tb/Ta} \le 0{,}90 \cdots \text{Ausdruck (1)}.$$

3. Zusammensetzung zum Bilden eines Lichtstreuungsverbunds (12) gemäß Anspruch 1 oder 2, weiterhin umfassend Leuchtstoffteilchen (13).

4. Lichtstreuungsverbund (12), der durch Aushärten der Zusammensetzung zum Bilden eines Lichtstreuungsverbunds gemäß einem der Ansprüche 1 bis 3 gebildet wird,
wobei mindestens einige der oberflächenmodifizierten anorganischen Oxidteilchen assoziierte Teilchen bilden, und ein durchschnittlicher Teilchendurchmesser aller Teilchen, die durch die oberflächenmodifizierten anorganischen Oxidteilchen gebildet sind, 10 nm oder mehr und 1000 nm oder weniger beträgt.

5. Lichtstreuungsverbund (12) gemäß Anspruch 4, wobei alle Teilchen, die durch die oberflächenmodifizierten anorganischen Oxidteilchen gebildet sind, gleichmäßig in dem Lichtstreuungsverbund verteilt sind.

6. Verfahren zur Herstellung eines Lichtstreuungsverbunds (12), umfassend:

einen Schritt des Aushärtens einer Zusammensetzung zum Bilden eines Lichtstreuungsverbunds, umfassend oberflächenmodifizierte anorganische Oxidteilchen, die durch ein Oberflächenmodifikationsmaterial oberflächenmodifiziert sind, das eine oder mehrere funktionelle Gruppen aufweist, die aus einer Gruppe ausgewählt sind, die aus einer Alkenylgruppe, einer H-Si-Gruppe und einer Alkoxygruppe besteht, und eine ungehärtete Matrixharzzusammensetzung, wobei ein durchschnittlicher Durchmesser verteilter Teilchen der oberflächenmodifizierten anorganischen Oxidteilchen 3 nm oder mehr und 150 nm oder weniger beträgt und **dadurch gekennzeichnet ist, dass** ein Gehalt der oberflächenmodifizierten anorganischen Oxidteilchen 0,01 Massen-% oder mehr und 5 Massen-% oder weniger in Bezug auf eine Gesamtmenge der Zusammensetzung zum Bilden eines Lichtstreuungsverbunds beträgt,
wobei während des Aushärtens mindestens einige der verteilten Teilchen in der Zusammensetzung zum Bilden eines Lichtstreuungsverbunds zugeordnet sind, um assoziierte Teilchen in einem Matrixharz zu bilden.

7. Verfahren zur Herstellung eines Lichtstreuungsverbunds (12) gemäß Anspruch 6,
wobei das Aushärten so durchgeführt wird, dass ein durchschnittlicher Teilchendurchmesser aller Teilchen, die durch die oberflächenmodifizierten anorganischen Oxidteilchen in dem Lichtstreuungsverbund gebildet werden, größer ist als der durchschnittliche Durchmesser verteilter Teilchen in der Zusammensetzung zum Bilden eines Lichtstreuungsverbunds und 10 nm oder mehr und 1000 nm oder weniger beträgt.

8. Optische lichtemittierende Halbleitervorrichtung, umfassend ein optisches lichtemittierendes Halbleiterelement (10), Leuchtstoffteilchen (13) und einen Lichtstreuungsverbund (12) gemäß Anspruch 4.

**Revendications**

1. Composition pour former un composite de diffusion de lumière (12), comprenant :

des particules d'oxyde inorganique modifiées en surface modifiées en surface par un matériau de modification de surface ayant un ou plusieurs groupes fonctionnels choisis dans un groupe constitué par un groupe alcényle, un groupe H-Si et un groupe alcoxy ; et
une composition de résine de matrice non durcie,
où un diamètre de particule dispersée moyen des particules d'oxyde inorganique modifiées en surface est de 3 nm ou plus et de 150 nm ou moins et **caractérisée en ce qu'**une teneur des particules d'oxyde inorganique modifiées en surface est de 0,01 % en masse ou plus et 5 % en masse ou moins par rapport à une quantité totale de la composition pour former un composite de diffusion de lumière.

2. Composition pour former un composite de diffusion de lumière (12) selon la revendication 1, dans laquelle un facteur de transmission Ta à une longueur d'onde de 550 nm mesurée avec une sphère d'intégration par rapport à la composition avant le durcissement et un facteur de transmission Tb à une longueur d'onde de 550 nm mesurée avec une sphère d'intégration par rapport à un produit durci après durcissement satisfont une relation de l'expression (1),

$$\text{Tb/Ta} \leq 0,90 \quad \text{expression (1).}$$

3. Composition pour former un composite de diffusion de lumière (12) selon la revendication 1 ou 2, comprenant en outre des particules de phosphore (13).

4. Composite de diffusion de lumière (12) formé par le durcissement de la composition pour former un composite de diffusion de lumière selon l'une quelconque de revendications 1 à 3, dans lequel au moins au moins une partie des particules d'oxyde inorganique modifiées en surface forment des particules associées, et un diamètre de particule moyen de toutes les particules formées par les particules d'oxyde inorganique modifiées en surface est de 10 nm ou plus et de 1000 nm ou moins.

5. Composite de diffusion de lumière (12) selon la revendication 4, dans lequel toutes les particules formées par les particules d'oxyde inorganique modifiées en surface sont uniformément dispersée dans le composite de diffusion de lumière.

6. Procédé de production d'un composite de diffusion de lumière (12), comprenant :

une étape de durcissement d'une composition pour former un composite de diffusion de lumière, comprenant des particules d'oxyde inorganique modifiées en surface modifiées en surface par un matériau de modification de surface ayant un ou plusieurs groupes fonctionnels choisis dans un groupe constitué par un groupe alcényle, un groupe H-Si et un groupe alcoxy, et une composition de résine de matrice non durcie, dans laquelle un diamètre de particule dispersée moyen des particules d'oxyde inorganique modifiées en surface est de 3 nm ou plus et de 150 nm ou moins, et **caractérisée en ce qu'**une teneur des particules d'oxyde inorganique modifiées en surface est de 0,01 % en masse ou plus et de 5 % en masse ou moins par rapport à une quantité totale de la composition pour former un composite de diffusion de lumière, où durant le durcissement, au moins une partie des particules dispersées dans la composition pour former un composite de diffusion de lumière sont associées pour former des particules associées dans une résine de matrice.

7. Procédé de production d'un composite de diffusion de lumière (12) selon la revendication 6, dans lequel le durcissement est réalisé de sorte qu'un diamètre de particule moyen de toutes les particules formées par les particules d'oxyde inorganique modifiées en surface dans le composite de diffusion de lumière est plus grand que le diamètre de particule dispersée moyen dans la composition pour former un composite de diffusion de lumière, et est de 10 nm ou plus et de 1000 nm ou moins.

8. Dispositif électroluminescent semiconducteur optique, comprenant un élément électroluminescent semiconducteur optique (10), des particules de phosphore (13) et un composite de diffusion de lumière (12) selon la revendication 4.

FIG.1

FIG.2

FIG.3

FIG.4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011129661 A
- JP 2014004514 C
- US 20150021643 A1